# EUROPEAN PATENT APPLICATION

(11) **EP 3 618 583 A1**
(43) Date of publication of application: **04.03.2020**
(21) Application number: 18791890.9
(22) Date of filing: 23.04.2018
(51) Int. Cl.: H05K 1/02, H01L 23/12, H01L 23/36, H01L 33/64

(54) **ELECTRONIC ELEMENT MOUNTING SUBSTRATE, ELECTRONIC DEVICE, AND ELECTRONIC MODULE**

(30) Priority: 25.04.2017 JP 2017086308; 30.10.2017 JP 2017209387
(71) Applicant: KYOCERA Corporation, Kyoto 612-8501 (JP)
(72) Inventor: KITAZUMI,Noboru, Kyoto-shi Kyoto 612-8501 (JP)
(74) Representative: Viering, Jentschura & Partner mbB Patent- und Rechtsanwälte
(86) International application number: PCT/JP2018/016457
(87) International publication number: WO 2018/199022

(57) **Abstract**

An electronic element mounting substrate includes a substrate in a quadrangular shape, including a first main surface and a second main surface opposite to the first main surface, and heat dissipators arrayed and embedded in the substrate, made of a carbon material, and including a third main surface located on the first main surface side in a thickness direction and a fourth main surface opposite to the third main surface. The heat dissipators have, in a plan perspective view, greater heat conduction in a direction perpendicular to a direction in which the heat dissipators are arrayed than heat conduction in the direction in which the heat dissipators are arrayed.

## Description

### Technical Field

The present invention relates to an electronic element mounting substrate, an electronic device, and an electronic module.

### Background Art

In the related art, an electronic element mounting substrate includes an insulating substrate having a first main surface, a second main surface, and side surfaces, and an electronic element mounting portion and a wiring layer located on the first main surface of the insulating substrate. In the electronic element mounting substrate, an electronic element is mounted on the electronic element mounting portion, and the electronic element mounting substrate with the electronic element is then mounted on an electronic element mounting package to form an electronic device (for example, refer to Japanese Unexamined Patent Application Publication No. 2013-175508).

### Summary of Invention

An electronic element mounting substrate according to the present disclosure includes a substrate in a quadrangular shape having a first main surface and a second main surface opposite to the first main surface, and heat dissipators arrayed and embedded in the substrate, made of a carbon material, and having a third main surface located on the first main surface side in a thickness direction and a fourth main surface opposite to the third main surface, in which the heat dissipators have, in a plan perspective view, greater heat conduction in a direction perpendicular to a direction in which the heat dissipators are arrayed than heat conduction in the direction in which the heat dissipators are arrayed.

An electronic device according to the present disclosure includes the electronic element mounting substrate having the above-described structure, an electronic element mounted on a mounting portion of the electronic element mounting substrate, and a wiring board or an electronic element housing package on which the electronic element mounting substrate is mounted.

An electronic module according to the present disclosure includes the electronic device having the above-described structure, and a module substrate to which the electronic device is connected.

### Brief Description of Drawings

Fig. 1(a) is a top view illustrating an electronic element mounting substrate according to a first embodiment, and Fig. 1(b) is a bottom view of Fig. 1(a).
Fig. 2 is an exploded perspective view of a substrate and heat dissipators of the electronic element mounting substrate illustrated in Fig. 1.
Fig. 3(a) is a longitudinal sectional view taken along line A-A of the electronic element mounting substrate illustrated in Fig. 1(a), and Fig. 3(b) is a longitudinal sectional view taken along line B-B of the electronic element mounting substrate illustrated in Fig. 1(a).
Fig. 4(a) is a top view illustrating a state where electronic elements are mounted on the electronic element mounting substrate illustrated in Fig. 1(a), and Fig. 4(b) is a longitudinal sectional view taken along line B-B in Fig. 4(a).
Fig. 5(a) is a top view illustrating an electronic element mounting substrate according to a second embodiment, and Fig. 5(b) is a bottom view of Fig. 5(a).
Fig. 6 is an exploded perspective view of a substrate and heat dissipators of the electronic element mounting substrate illustrated in Fig. 5.
Fig. 7(a) is a longitudinal sectional view taken along line A-A of the electronic element mounting substrate illustrated in Fig. 5(a), and Fig. 7(b) is a longitudinal sectional view taken along line B-B of the electronic element mounting substrate illustrated in Fig. 5(a).
Fig. 8(a) is a top view illustrating a state where electronic elements are mounted on the electronic element mounting substrate illustrated in Fig. 5(a), and Fig. 8(b) is a longitudinal sectional view taken along line B-B in Fig. 8(a).
Fig. 9(a) is a top view illustrating an electronic element mounting substrate according to a third embodiment, and Fig. 9(b) is a bottom view of Fig. 9(a).
Fig. 10 is an exploded perspective view of a substrate and heat dissipators of the electronic element mounting substrate illustrated in Fig. 9.
Fig. 11(a) is a longitudinal sectional view taken along line A-A of the electronic element mounting substrate illustrated in Fig. 9(a), and Fig. 11(b) is a longitudinal sectional view taken along line B-B of the electronic element mounting substrate illustrated in Fig. 9(a).
Fig. 12(a) is a top view illustrating a state where electronic elements are mounted on the electronic element mounting substrate illustrated in Fig. 9(a), and Fig. 12(b) is a longitudinal sectional view taken along line B-B in Fig. 12(a).
Fig. 13(a) is a top view illustrating an electronic element mounting substrate according to a fourth embodiment, and Fig. 13(b) is a bottom view of Fig. 13(a).
Fig. 14 is an exploded perspective view of a substrate and heat dissipators of the electronic element mounting substrate illustrated in Fig. 13.
Fig. 15(a) is a longitudinal sectional view taken along line A-A of the electronic element mounting substrate illustrated in Fig. 13(a), and Fig. 15(b) is a longitudinal sectional view taken along line B-B of the electronic element mounting substrate illustrated in Fig. 13(a).
Fig. 16(a) is a top view illustrating a state where electronic elements are mounted on the electronic element mounting substrate illustrated in Fig. 13(a), and Fig. 16(b) is a longitudinal sectional view taken along line B-B in Fig. 16(a).
Fig. 17(a) is a top view illustrating an electronic element mounting substrate according to a fifth embodiment, and Fig. 17(b) is a bottom view of Fig. 17(a).
Fig. 18 is an exploded perspective view of a substrate and heat dissipators of the electronic element mounting substrate illustrated in Fig. 17.
Fig. 19(a) is a longitudinal sectional view taken along line A-A of the electronic element mounting substrate illustrated in Fig. 17(a), and Fig. 19(b) is a longitudinal sectional view taken along line B-B of the electronic element mounting substrate illustrated in Fig. 17(a).
Fig. 20(a) is a top view illustrating a state where electronic elements are mounted on the electronic element mounting substrate illustrated in Fig. 17(a), and Fig. 20(b) is a longitudinal sectional view taken along line B-B in Fig. 20 (a).
Fig. 21(a) is a top view illustrating an electronic element mounting substrate according to a sixth embodiment, and Fig. 21(b) is a bottom view of Fig. 21(a).
Fig. 22 is an exploded perspective view of a substrate and heat dissipators of the electronic element mounting substrate illustrated in Fig. 21.
Fig. 23(a) is a longitudinal sectional view taken along line A-A of the electronic element mounting substrate illustrated in Fig. 21(a), and Fig. 23(b) is a longitudinal sectional view taken along line B-B of the electronic element mounting substrate illustrated in Fig. 21(a).
Fig. 24(a) is a top view illustrating a state where electronic elements are mounted on the electronic element mounting substrate illustrated in Fig. 21(a), and Fig. 24(b) is a longitudinal sectional view taken along line B-B in Fig. 24(a).
Fig. 25(a) is a top view illustrating another example of the electronic element mounting substrate according to the sixth embodiment, and Fig. 25(b) is a bottom view of Fig. 25(a).
Fig. 26(a) is a top view illustrating an electronic element mounting substrate according to a seventh embodiment, and Fig. 26(b) is a bottom view of Fig. 26(a).
Fig. 27 is an exploded perspective view of a substrate and heat dissipators of the electronic element mounting substrate illustrated in Fig. 26.
Fig. 28(a) is a longitudinal sectional view taken along line A-A of the electronic element mounting substrate illustrated in Fig. 26(a), and Fig. 28(b) is a longitudinal sectional view taken along line B-B of the electronic element mounting substrate illustrated in Fig. 26(a).
Fig. 29(a) is a top view illustrating a state where electronic elements are mounted on the electronic element mounting substrate illustrated in Fig. 26(a), and Fig. 29(b) is a longitudinal sectional view taken along line B-B in Fig. 29(a).
Fig. 30(a) is a top view illustrating another example of the electronic element mounting substrate according to the seventh embodiment, and Fig. 30(b) is a bottom view of Fig. 30(a).
Fig. 31(a) is a top view illustrating an electronic element mounting substrate according to an eighth embodiment, and Fig. 31(b) is a bottom view of Fig. 31(a).
Fig. 32 is an exploded perspective view of a substrate and a heat dissipator of the electronic element mounting substrate illustrated in Fig. 31.
Fig. 33(a) is a longitudinal sectional view taken along line A-A of the electronic element mounting substrate illustrated in Fig. 31(a), and Fig. 33(b) is a longitudinal sectional view taken along line B-B of the electronic element mounting substrate illustrated in Fig. 31(a).
Fig. 34(a) is a top view illustrating a state where electronic elements are mounted on the electronic element mounting substrate illustrated in Fig. 31(a), and Fig. 34(b) is a longitudinal sectional view taken along line B-B in Fig. 34(a).
Fig. 35(a) is a top view illustrating another example of the electronic element mounting substrate according to the eighth embodiment, and Fig. 35(b) is a bottom view of Fig. 35(a).

### Description of Embodiments

Several exemplary embodiments of the present disclosure will be described with reference to the accompanying drawings.

### (First Embodiment)

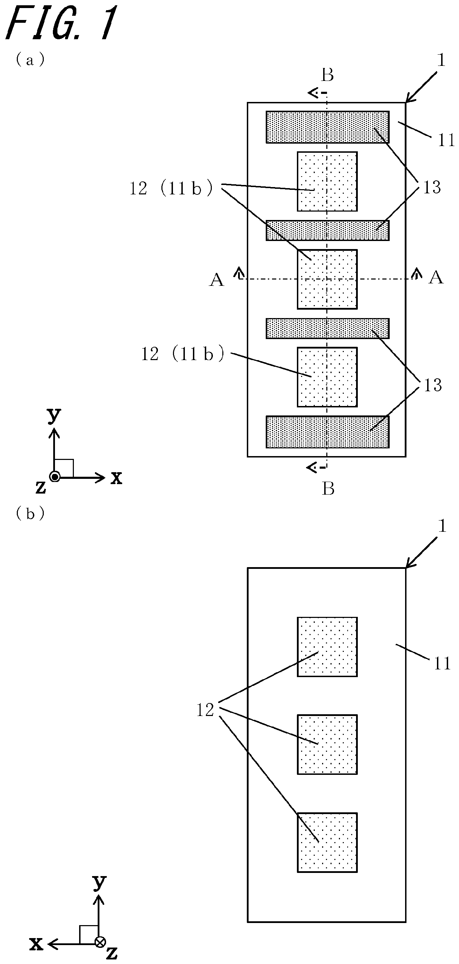

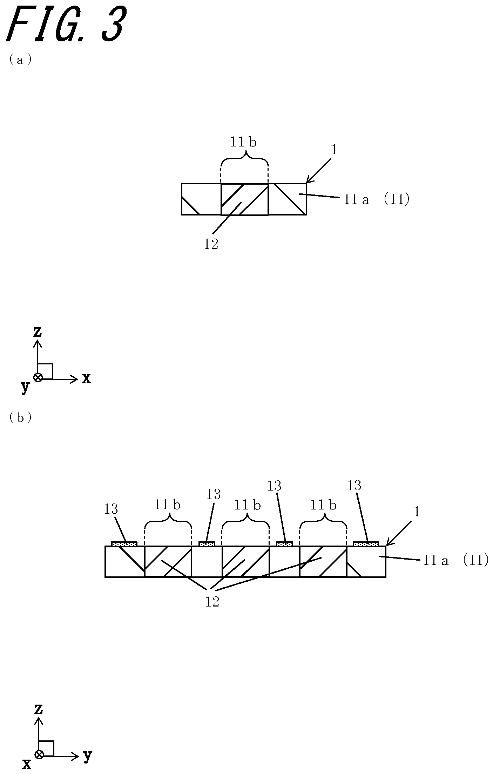

An electronic element mounting substrate 1 according to a first embodiment includes a substrate 11, a substrate 11, and a heat dissipator 12, as in an example illustrated in Figs. 1 to 4. An electronic device includes an electronic element substrate 1, an electronic element 2 mounted on a mounting portion 11a of the electronic element mounting substrate, and a wiring board on which the electronic element mounting substrate 1 is mounted. For example, the electronic device is connected to a connection pad on a module substrate constituting an electronic module by using a bonding material.

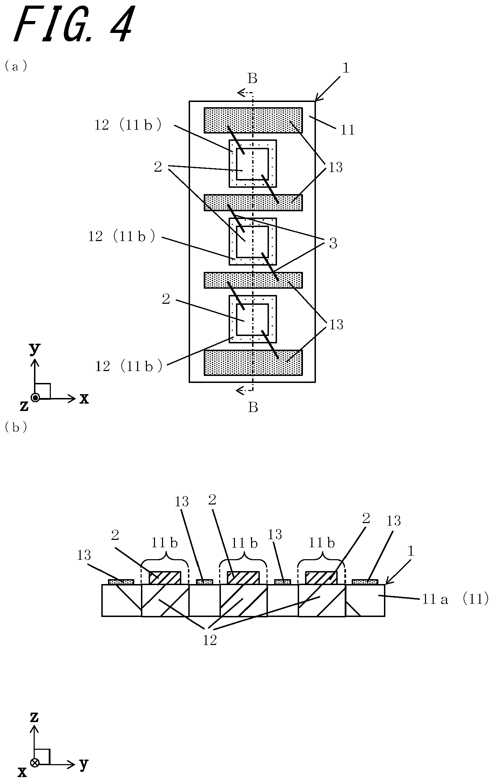

The electronic element mounting substrate 1 in the present embodiment includes the substrate 11 in a quadrangular shape and having a first main surface 111 and a second main surface 112 opposite to the first main surface 111, and heat dissipators 12 arrayed and embedded in the substrate 11, made of a carbon material, and having a third main surface 121 located on the first main surface 111 side in a thickness direction and a fourth main surface 122 opposite to the third main surface 121. In the heat dissipator 12, heat conduction in a direction perpendicular to a direction in which the heat dissipators 12 are arrayed is greater than heat conduction in the direction in which the heat dissipators 12 are arrayed, in a plan perspective view. The substrate 11 includes a metal layer 13 on a surface. In Fig. 4, the electronic element 2 is mounted on an xy plane in a virtual xyz space. In Figs. 1 to 4, an upward direction means a positive direction of a virtual z axis. The distinction between the upper and lower in the following description is for convenience, and does not limit the upper and lower when the electronic element mounting substrate 1 or the like is actually used.

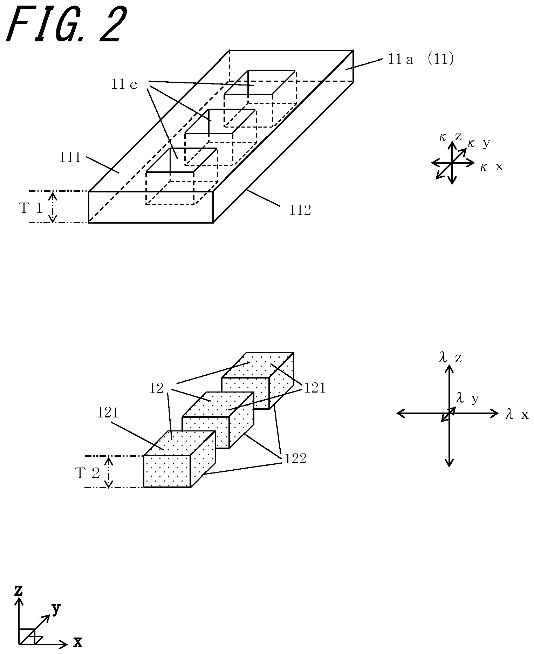

The heat dissipators 12 are shown by hatching in the example illustrated in Figs. 1 and 2. The metal layers 13 are shown by hatching in the example illustrated in Figs. 1(a), 3(b), and 4. In the example illustrated in Fig. 2, an outer surface of the substrate 11 and an inner surface of a hole 11c which are invisible in perspective are shown by broken lines in the substrate 11. A mounting portion 11b for the electronic element 2 is disposed to overlap the heat dissipator 12 in a plan perspective view. A plurality of mounting portions 11b for electronic components 2 is disposed in a direction (y direction) in which the heat dissipators 12 are arrayed in a plan view. In the example illustrated in Figs. 1 to 4, three mounting portions 11b for electronic components 2 are located in the direction (y direction) in which the heat dissipators 12 are arrayed in a plan view.

The substrate 11 is formed of a single insulating layer 11a or a plurality of insulating layers 11a, and includes the first main surface 111 (upper surface in Figs. 1 to 4) and the second main surface 112 (lower surface in Figs. 1 to 4). The substrate 11 includes the single insulating layer 11a in the example illustrated in Figs. 1 to 4. The substrate 11 has a quadrangular plate-like shape having two sets of opposite sides (four sides) with respect to each of the first main surface 111 and the second main surface 112 in a plan view. In the example illustrated in Figs. 1 to 4, the substrate 11 has a rectangular shape having a long side in the direction of the arrangement of a plurality of electronic elements 2 (arrangement of the mounting portions 11b) in a plan view. The substrate 11 functions as a support for supporting the plurality of electronic elements 2, and the plurality of electronic elements 2 is bonded and fixed on a plurality of mounting portions 11b located on the first main surface 111 of the substrate 11 through bonding members, respectively.

For example, ceramics such as an aluminum oxide sintered body (alumina ceramic), an aluminum nitride sintered body, a mullite sintered body, or a glass ceramic sintered body can be used for the substrate 11. When the substrate 11 is an aluminum nitride sintered body, for example, an appropriate organic binder, solvent, and the like are added to and mixed with raw material powder of aluminum nitride (AlN), erbium oxide (Er₂O₃), yttrium oxide (Y₂O₃) or the like to prepare a slurry. A ceramic green sheet is prepared by using the slurry to form a sheet by a known doctor blade method or calendar roll method in the related art. If necessary, a plurality of ceramic green sheets is laminated, and the ceramic green sheets are fired at a high temperature (approximately 1,800°C) to prepare the substrate 11 made of the single insulating layer 11a or the plurality of insulating layers 11a.

The substrate 11 include a hole 11c accommodating the heat dissipator 12. In the electronic element mounting substrate 1 according to the first embodiment, the hole 11c penetrates from the first main surface 111 to the second main surface 112 of the substrate 11. The hole 11c can be formed, for example, by forming a through-hole to be the hole 11c in the ceramic green sheet, by performing laser processing, punching processing using a mold, or the like on the ceramic green sheet for the substrate 11.

The heat dissipator 12 includes the third main surface 121 (upper surface in Figs. 1 to 4) and the fourth main surface 122 (lower surface in Figs. 1 to 4). The heat dissipator 12 has a quadrangular plate-like shape having two sets of opposite sides (four sides) with respect to each of the third main surface 121 and the fourth main surface 122 in a plan view.

The heat dissipator 12 is formed as a structure made of, for example, a carbon material, by laminating graphene in which six-membered rings are connected by a covalent bond. It is a material in which each of the surfaces are bonded by van der Waals forces.

The heat dissipator 12 is accommodated in the hole 11c of a substrate 11 and embedded in the substrate 11. In the example illustrated in Figs. 1 to 4, the heat dissipator 12 is embedded in each of the three holes 11c disposed side by side (arrayed) in a longitudinal direction of the substrate 11 and embedded in the substrate 11. In the example illustrated in Figs. 1 to 4, in the heat dissipator 12, the third main surface 121 is exposed to the first main surface 111 side in the thickness direction of the substrate 11, and the fourth main surface 122 is exposed to the second main surface 112 side in the thickness direction of the substrate 11.

As the substrate 11, an aluminum nitride sintered body having good thermal conductivity may be used. In the substrate 11 and the heat dissipator 12, the inner surface of the hole 11c of the substrate 11 and the outer surface of the heat dissipator 12 are bonded to each other by a bonding material made of an active brazing material such as a TiCuAg alloy. The bonding material is disposed with a thickness of approximately 10 µm between the substrate 11 and the heat dissipator 12.

In the electronic element mounting substrate 1 according to the first embodiment, a substrate thickness T1 of the substrate 11 and a substrate thickness T2 of the heat dissipator 12 are each approximately 100 µm to 2,500 µm. In the electronic element mounting substrate 1 according to the first embodiment, the substrate thickness T1 of the substrate 11 and the substrate thickness T2 of the heat dissipator 12 are equivalent within a range of approximately 5% (0.95T1 ≤ T2 ≤ 1.05T1).

As in the example illustrated in Fig. 2, the thermal conductivity κ of the substrate 11 is substantially constant in the x direction and the y direction in a planar direction, and is also substantially constant in the planar direction and the thickness direction of the substrate 11 (κx ≈ κy ≈ κz). For example, when an aluminum nitride sintered body is used as the substrate 11, the substrate 11 having a thermal conductivity κ of approximately 100 to 200 W/m·K is used.

The thermal conductivity λ of the heat dissipator 12 differs in magnitude between the x direction and the y direction in the planar direction. For example, the relationship between the thermal conductivities λx, λy, and λz in the respective directions of the heat dissipator 12 is "thermal conductivity λx ≈ thermal conductivity λz >> thermal conductivity λy" as illustrated in Fig. 2. For example, the thermal conductivity λx and the thermal conductivity λz of the heat dissipator 12 are approximately 1,000 W/m·K, and the thermal conductivity λy of the heat dissipator 12 is approximately 4 W/m·K. The heat dissipator 12 is disposed so that the heat conduction in the direction perpendicular to the direction in which the heat dissipators 12 are arrayed is greater than the heat conduction in the direction in which the heat dissipators 12 are arrayed in a plan perspective view.

For example, the thermal conductivity of the electronic element mounting substrate 1 according to the present embodiment can be measured by an analysis method such as a laser flash method. When the thermal conductivity of the heat dissipator 12 is measured, the bonding material bonding the substrate 11 and the heat dissipator 12 is removed, and measurement can be performed on the heat dissipator 12 by an analysis method such as a laser flash method.

The heat dissipators 12 are disposed so that the thermal conductivity λy in the longitudinal direction of the substrate 11, that is, the direction between the mounting portions 11b for the adjacent electronic elements 2 is smaller than the thermal conductivity λx in a direction perpendicular to the longitudinal direction of the substrate 11 and the thermal conductivity λz in the thickness direction of the heat dissipator 12.

The metal layers 13 are positioned on the first main surface 111 of the substrate 11 such that the heat dissipators 12 is interposed between the metal layers 13 in the longitudinal direction of the substrate 11 (direction in which the heat dissipators 12 are arrayed) in a plan view (plan perspective view). The metal layers 13 and the heat dissipators 12 are alternately positioned in the longitudinal direction of the substrate 11 in a plan view (plan perspective view). The metal layer 13 is used as, for example, a connection portion with a connection member 3 such as a bonding wire bonding to an electrode of the electronic element 2.

The metal layer 13 includes a thin film layer and a plating layer. The thin film layer has, for example, an adhesion metal layer and a barrier layer. The adhesion metal layer constituting the thin film layer is formed on the first main surface of the substrate 11. The adhesion metal layer is made of, for example, tantalum nitride, nickel-chromium, nickel-chromium-silicon, tungsten-silicon, molybdenum-silicon, tungsten, molybdenum, titanium, chromium, or the like, and is deposited on the first main surface of the substrate 11 by adopting a thin film forming technique such as a vapor deposition method, an ion plating method, a sputtering method, or the like. For example, when the adhesion metal layer is formed by using a vacuum evaporation method, the substrate 11 is installed in a film forming chamber of a vacuum evaporation apparatus, and a metal piece to be an adhesion metal layer is disposed as a vapor deposition source in the film forming chamber. Thereafter, the film forming chamber is in a vacuum state (pressure of 10⁻² Pa or less), and the metal piece disposed as the vapor deposition source is heated and vapor-deposited, and molecules of the vapor-deposited metal piece are deposited on the substrate 11. Therefore, a thin film metal layer to be an adhesion metal layer is formed. After a resist pattern is formed by using a photolithography method on the substrate 11 on which the thin film metal layer is formed, an excess thin film metal layer is removed by etching, and thus an adhesion metal layer is formed. A barrier layer is deposited on the upper surface of the adhesion metal layer. The barrier layer has good adhesion and wettability with the adhesion metal layer and the plating layer, and functions to firmly bond the adhesion metal layer and the plating layer and to prevent mutual diffusion between the adhesion metal layer and the plating layer. The barrier layer is made of, for example, nickel-chromium, platinum, palladium, nickel, cobalt, or the like, and is deposited on the surface of the adhesion metal layer by a thin film forming technique such as a vapor deposition method, an ion plating method, or a sputtering method.

The thickness of the adhesion metal layer is preferably approximately 0.01 to 0.5 µm. When the thickness is less than 0.01 µm, it tends to be difficult to cause the adhesion metal layer to firmly adhere to the substrate 11. When the thickness exceeds 0.5 µm, the adhesion metal layer is likely to separate due to internal stress during film formation of the adhesion metal layer. The thickness of the barrier layer is preferably approximately 0.05 to 1 µm. When the thickness is less than 0.05 µm, defects such as pinholes occur, and it tends to be difficult to perform the function as a barrier layer. When the thickness exceeds 1 µm, the barrier layer is likely to separate due to internal stress during film formation.

The plating layer is deposited on the surface of the thin film layer by an electrolytic plating method or an electroless plating method. The plating layer is made of a metal having good corrosion resistance and connectivity with a connection member, such as nickel, copper, gold, or silver. For example, a nickel plating layer having a thickness of approximately 0.5 to 5 µm and a gold plating layer having a thickness of approximately 0.1 to 3 µm are sequentially deposited. As a result, corrosion of the metal layer 13 can be effectively suppressed, and the bonding between the metal layer 13 and the wiring conductor on the wiring board can be strengthened.

A metal layer such as copper (Cu) or gold (Au) may be disposed on the barrier layer so that the plating layer is appropriately formed. Such a metal layer is formed by a similar method to the method for the thin film layer.

When the metal layer 13 is disposed on the first main surface 111 of the substrate 11 and the metal plating layer is disposed on the metal layer 13, if a protective film made of resin, ceramics, metal, or the like is placed in advance on the third main surface 121 and the fourth main surface 122 where the heat dissipator 12 is exposed, since the heat dissipator 12 made of a carbon material is not exposed when the electronic element mounting substrate 1 is manufactured, alteration due to chemicals or the like can be reduced.

By mounting the electronic element 2 on the mounting portion 11b located on the first main surface 111 of the electronic element mounting substrate 1, and mounting the electronic element mounting substrate 1 on a wiring board or an electronic element mounting package, an electronic device can be manufactured. The electronic element 2 mounted on the electronic element mounting substrate 1 is, for example, a light emitting element such as a laser diode (LD) or a light emitting diode (LED), or a light receiving element such as a photo diode (PD). For example, after the electronic element 2 is fixed on the mounting portion 11b by a bonding material such as Au-Sn, the electrode of the electronic element 2 and the metal layer 13 are electrically connected through the connecting member 3 such as a bonding wire, and the electronic element 2 is thus mounted on the electronic element mounting substrate 1. The wiring board or electronic element mounting package on which the electronic element mounting substrate 1 is mounted can use an insulating substrate such as ceramics, and has a wiring conductor on the surface, for example, similarly to the substrate 11. The metal layer 13 of the electronic element mounting substrate 1 and the wiring conductor of the wiring board or electronic element mounting package are electrically connected to each other.

The electronic device according to the present embodiment is connected to the wiring conductor and the connection pad of the module substrate through a bonding material such as solder to form an electronic module. As a result, the electronic element 2 and the connection pad of the module substrate are electrically connected to each other.

According to the electronic element mounting substrate 1 according to the present embodiment, the substrate 11 in the quadrangular shape and having the first main surface 111 and the second main surface 112 opposite to the first main surface 111, and the heat dissipators 12 arrayed and embedded in the substrate 11, made of a carbon material, and has the third main surface 121 located on the first main surface 111 side in the thickness direction and the fourth main surface 122 opposite to the third main surface 121 are disposed. In a plan perspective view, in the heat dissipators 12, the heat conduction in the direction perpendicular to the direction in which the heat dissipators 12 are arrayed is greater than the heat conduction in the direction in which the heat dissipators 12 are arrayed. Therefore, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate, the heat dissipation of the electronic element mounting substrate 1 is improved, and the warp of the electronic element mounting substrate 1 can be suppressed.

In particular, when an optical element such as an LD or LED is mounted as the electronic element 2, by suppressing the warp of the electronic element mounting substrate 1, the electronic element mounting substrate 1 for an optical device capable of emitting light with high accuracy can be obtained.

The electronic element mounting substrate 1 according to the present embodiment can be suitably used in a thin and high-power electronic device, and the reliability of the electronic element mounting substrate 1 can be improved. For example, when an optical element such as an LD or LED is mounted as the electronic element 2, the electronic element mounting substrate 1 can be suitably used as the electronic element mounting substrate 1 for an optical device that is thin and good in directivity.

As shown in the example illustrated in Figs. 1 to 4, in a plan perspective view, when the heat dissipator 12 is larger than the mounting portion 11b (larger than the electronic element 2), the heat of the electronic element 2 transferred to the heat dissipator 12 is likely to be appropriately transferred in the direction perpendicular to the direction in which the heat dissipators 12 are arrayed, and the heat transfer in the direction in which the electronic elements 2 are adjacent to each other and the heat dissipators 12 are arrayed is suppressed. Therefore, the warp of the electronic element mounting substrate 1 can be suppressed.

As shown in the example illustrated in Figs. 1 to 4, in a plan perspective view, when the metal layer 13 does not overlap the heat dissipator 12, that is, is disposed outside the outer edge of the heat dissipator 12, the heat of the electronic element 2 is likely to be transferred toward the heat dissipator 12 than the metal layer 13, and the heat of the electronic element 2 is unlikely to be transferred to the position opposed to the electronic element 2 through the metal layer 13. Therefore, the warp of the electronic element mounting substrate 1 can be appropriately suppressed.

In a plan view (plan perspective view), when the metal layers 13 are positioned such that the heat dissipator 12 is interposed between the metal layers 13 in the direction in which the heat dissipators 12 are arrayed, the heat transferred to the metal layer 13 is likely to be dissipated at the metal layer 13, and the heat transfer through the metal layer 13 is suppressed in the direction in which the electronic elements 2 are adjacent to each other and the heat dissipators 12 are arrayed. Therefore, the heat of the electronic element 2 is appropriately transferred through the heat dissipator 12 in the direction perpendicular to the direction in which the heat dissipators 12 are arrayed, and the warp of the electronic element mounting substrate 1 can be suppressed more appropriately.

When the metal layer 13 and the heat dissipator 12 are alternately positioned in the direction in which the heat dissipators 12 are arrayed in a plan view (plan perspective view), the heat transferred to the metal layer 13 is likely to be effectively dissipated at the metal layer 13, and the heat transfer through the metal layer 13 is suppressed in the direction in which the electronic elements 2 are adjacent to each other and the heat dissipators 12 are arrayed. Therefore, the heat of the electronic element 2 is appropriately transferred through the heat dissipator 12 in the direction perpendicular to the direction in which the heat dissipators 12 are arrayed, and the warp of the electronic element mounting substrate 1 can be more appropriately suppressed.

In a longitudinal sectional view in the direction in which the heat dissipators 12 are arrayed, when the heat dissipator 12 has greater heat conduction in the thickness direction than the direction perpendicular to the thickness direction, the heat is likely to be appropriately transferred in the thickness direction of the heat dissipator 12, and the heat transfer in the direction in which the heat dissipators 12 are arrayed can be appropriately suppressed.

As in the example illustrated in Figs. 1 to 4, in a plan view, when the substrate 11 has a rectangular shape and the heat dissipators 12 are arrayed in the longitudinal direction of the substrate 11, each of the heat dissipators 12 suppresses heat transfer in the longitudinal direction of the substrate 11, and the heat of the electronic element 2 can be appropriately transferred in the direction perpendicular to the longitudinal direction of the substrate 11 through the heat dissipator 12.

In the heat dissipator 12, since the third main surface 121 is exposed to the first main surface 111 side in the thickness direction of the substrate 11, when the electronic element 2 is mounted on the heat dissipator 12 (mounting portion 11b), the heat of the electronic element 2 can be directly transferred to the heat dissipator 12, the heat transfer in the direction in which the heat dissipators 12 are arrayed is suppressed, and the heat is appropriately transferred in the direction perpendicular to the direction in which the heat dissipators 12 are arrayed. Therefore, the warp of the substrate 11 can be appropriately suppressed.

Since the fourth main surface 122 of the heat dissipator 12 is exposed to the second main surface 112 side in the thickness direction of the substrate 11, the heat transferred toward the fourth main surface 122 through the heat dissipator 12 can be likely to be released to the outside.

The electronic device according to the present embodiment includes the electronic element mounting substrate 1 having the above structure, the electronic element 2 mounted on the mounting portion 11b of the electronic element mounting substrate 1, and the wiring board or an electronic element housing package on which the electronic element mounting substrate 1 is mounted. Therefore, an electronic device having good long-term reliability can be obtained.

The electronic module according to the present embodiment includes the electronic device having the above structure and the module substrate to which the electronic device is connected. Therefore, an electronic module having good long-term reliability can be obtained.

### (Second Embodiment)

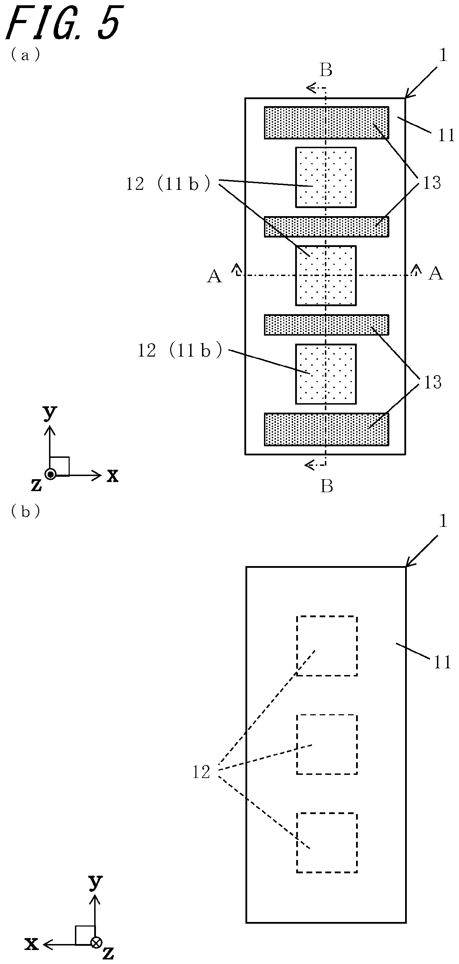

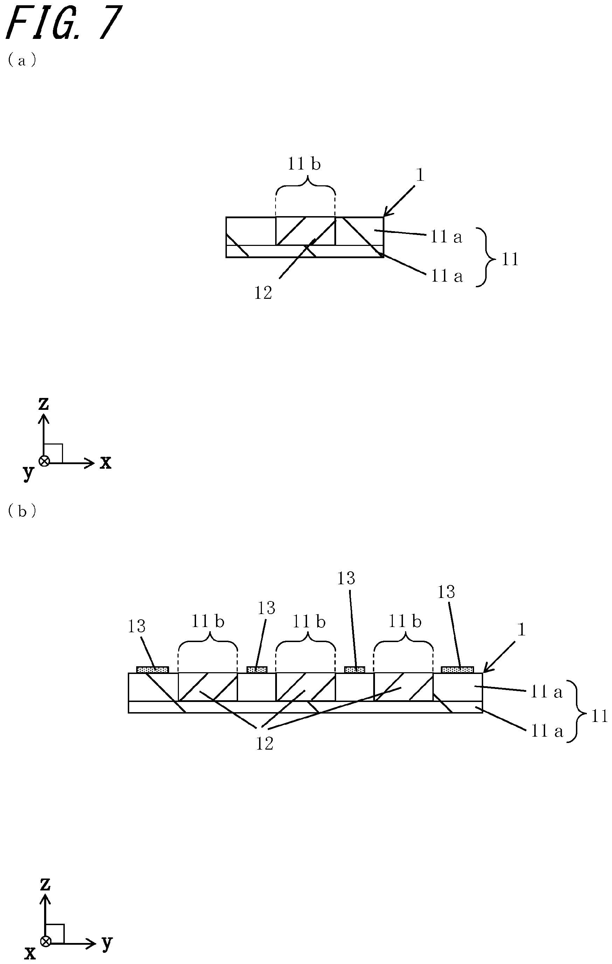

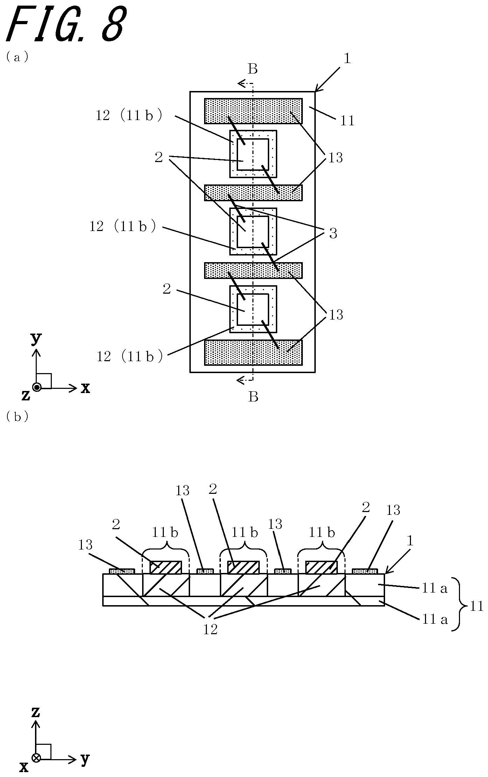

Next, an electronic element mounting substrate according to a second embodiment will be described with reference to Figs. 5 to 8.

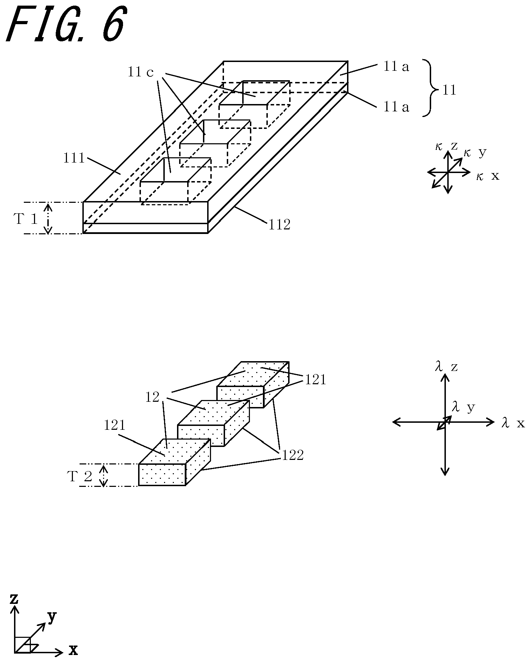

An electronic device according to the second embodiment is different from the electronic device according to the above-described embodiment in that the substrate 11 has a hole 11c having a bottom surface. In the second embodiment, the substrate 11 is formed of two insulating layers 11a. In the heat dissipator 12, in the example illustrated in Figs. 5 to 8, the third main surface 121 is exposed to the first main surface 111 side in the thickness direction of the substrate 11. The heat dissipator 1 is shown by hatching in the example illustrated in Figs. 5(a), 6, and 8(a). The metal layer 13 is shown by hatching in the example illustrated in Figs. 5(a), 7(b), and 8. In the substrate 11, in the example illustrated in Fig. 6, the outer surface of the substrate 11 and the inner surface of the hole 11c which are invisible in perspective are shown by broken lines. In the substrate 11, in the example illustrated in Fig. 5(b), a region that overlaps the side surface of the heat dissipator 12 in a plan perspective view is indicated by a broken line.

According to the electronic element mounting substrate 1 in the second embodiment, similarly to the electronic element mounting substrate 1 according to the above-described embodiment, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

The hole 11c opens to the first main surface 111 side of the substrate 11, and has the bottom surface located on the second main surface 112 side. The electronic element mounting substrate 1 according to the second embodiment can be manufactured by bonding the bottom surface of the hole 11c of the substrate 11 and the fourth main surface 122 of the heat dissipator 12. According to the electronic element mounting substrate 1 of the second embodiment, since the insulating layer 11a is disposed to the fourth main surface 122 side of the heat dissipator 12, the entire lower surface of the electronic element mounting substrate 1 including the fourth main surface 122 of the heat dissipator 12 can be held to reduce the warp of the electronic element mounting substrate 1. The entirety of the second main surface 112 of the substrate 11 is flat, other heat dissipating members can be appropriately bonded to the second main surface 112 of the substrate 11, and the electronic element mounting substrate 1 having good reliability can be obtained.

For example, the hole 11c can be formed by forming a through-hole to be the hole 11c in the ceramic green sheet by performing laser processing, punching processing using a mold, or the like on the ceramic green sheet for the substrate 11, and laminating the ceramic green sheet with other ceramic green sheet.

In the electronic element mounting substrate 1 according to the second embodiment, the bottom surface of the hole 11c of the substrate 11 and the fourth main surface 122 of the heat dissipator 2 are bonded to each other by a bonding material made of an active brazing material such as a TiCuAg alloy. The bonding material is disposed with a thickness of approximately 10 µm between the substrate 11 and the heat dissipator 12. The substrate thickness T1 of the substrate 11 is, for example, approximately 150 µm to 2,500 µm, and the substrate thickness T2 of the heat dissipator 12 is, for example, approximately 100 µm to 2,000 µm. The thickness T12 of the insulating layer 11a located on the second main surface 112 side of the substrate 11 may be smaller than the thickness T11 of the insulating layer 11a located on the first main surface 111 side of the substrate 11, that is, the height (depth) of the hole 11c (T11 > T12).

The electronic element mounting substrate 1 according to the second embodiment may be formed by bonding another substrate 11 that is substantially the same material as the substrate 11 located on the second main surface 112 side of the substrate 11 and the fourth main surface 122 side of the heat dissipator 12 of the electronic element mounting substrate 1 according to the first embodiment.

The electronic element mounting substrate 1 according to the second embodiment can be manufactured using the same manufacturing method as the electronic element mounting substrate 1 according to the above-described embodiment.

### (Third Embodiment)

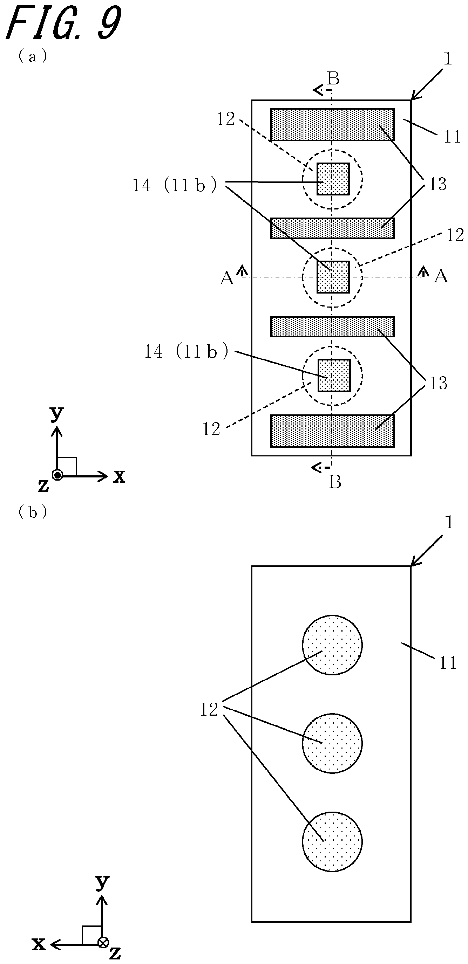

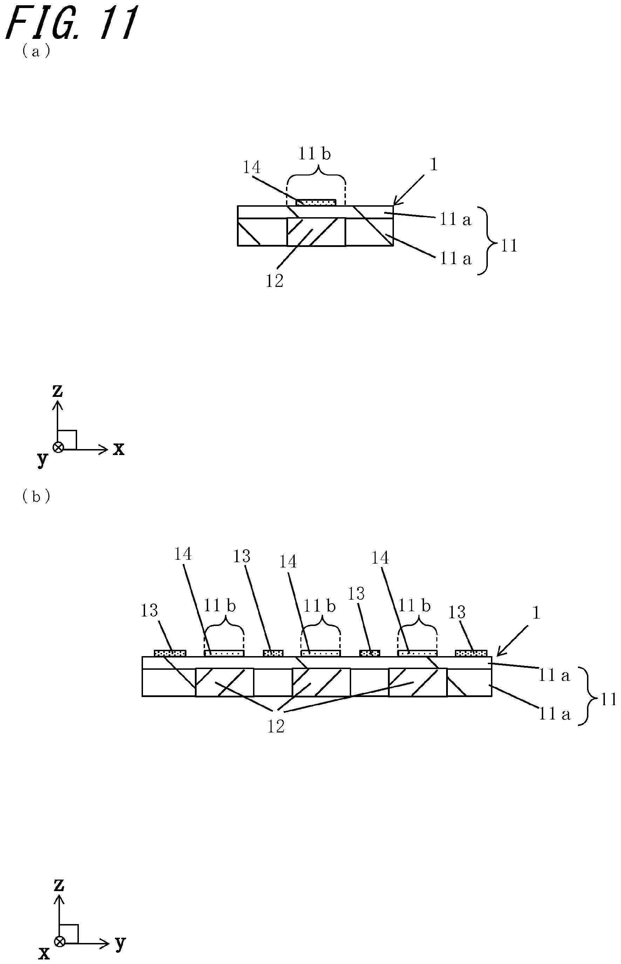

Next, an electronic device according to a third embodiment will be described with reference to Figs. 9 to 12.

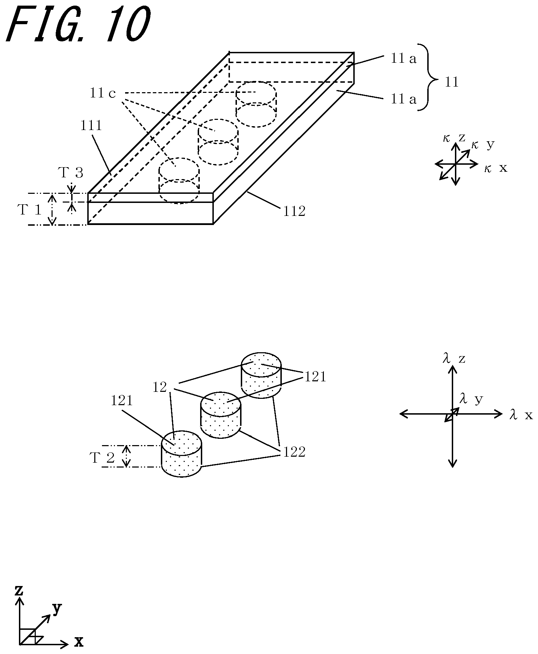

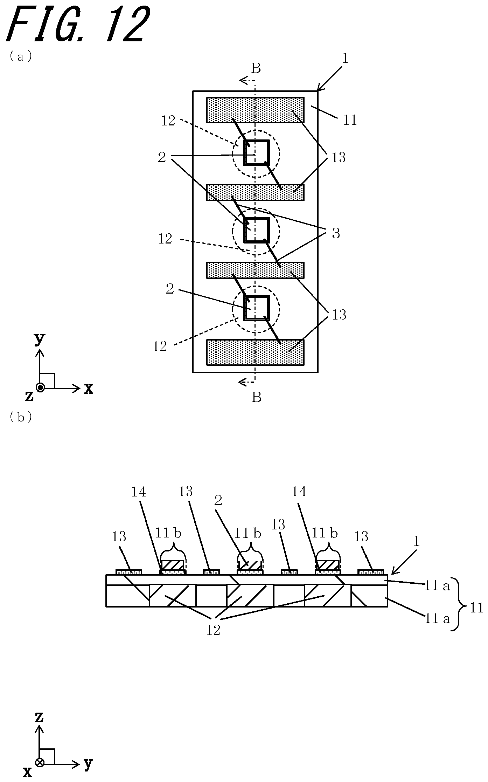

An electronic element mounting substrate 1 according to the third embodiment is different from the electronic element mounting substrate 1 according to the above-described embodiments in that a hole 11c having a bottom surface opened to the second main surface 112 of the substrate 11 is disposed, and that the heat dissipator 12 has a circular shape in a plan perspective view. In the third embodiment, the substrate 11 is formed of two insulating layers 11a. In the heat dissipator 12, in the example illustrated in Figs. 9 to 12, the fourth main surface 122 is exposed to the second main surface 112 side in the thickness direction of the substrate 11. The mounting portion 11b for the electronic element 2 and the heat dissipator 12 are shown by hatching in the example illustrated in Figs. 9(b) and 10. The metal layer 13 and a mounting layer 14 are shown by hatching in the example illustrated in Figs. 9, 11, and 12. In the substrate 11, in the example illustrated in Fig. 10, the outer surface of the substrate 11 and the inner surface of the hole 11c which are invisible in perspective are shown by broken lines. In the substrate 11, in the example illustrated in Figs. 9(a) and 12(a), a region that overlaps the side surface of the heat dissipator 12 in a plan perspective view is indicated by a broken line.

According to the electronic element mounting substrate 1 in the third embodiment, similarly to the electronic element mounting substrate 1 according to the above-described embodiments, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

The electronic element mounting substrate 1 according to the third embodiment can be manufactured by bonding the bottom surface of the hole 11c of the substrate 11 and the third main surface 121 of the heat dissipator 12. Since the insulating layer 11a is disposed to the third main surface 121 side of the heat dissipator 12, the entire upper surface of the electronic element mounting substrate 1 including the third main surface 121 of the heat dissipator 12 is held to reduce the warp of the electronic element mounting substrate 1. Therefore, the electronic element mounting substrate 1 having good reliability can be obtained. The entirety of the first main surface 111 of the substrate 11 is flat, and the electronic element 2 can be appropriately mounted on the mounting portion 11b.

For example, the hole 11c can be formed by forming a through-hole to be the hole 11c in the ceramic green sheet by performing laser processing, punching processing using a mold, or the like on the ceramic green sheet for the substrate 11, and laminating the ceramic green sheet with other ceramic green sheet.

The electronic element mounting substrate 1 according to the third embodiment is bonded by a bonding material made of an active brazing material such as a TiCuAg alloy. The bonding material is disposed with a thickness of approximately 10 µm between the substrate 11 and the heat dissipator 12. The thickness T1 of the substrate 11 is, for example, approximately 150 µm to 2,500 µm, and the thickness T2 of the heat dissipator 12 is, for example, approximately 100 µm to 2,000 µm. The thickness T12 of the insulating layer 11a located on the second main surface 112 side of the substrate 11 may be larger than the thickness T11 of the insulating layer 11a located on the first main surface 111 side of the substrate 11, that is, the height (depth) of the hole 11c. (T12 > T11).

As in the example illustrated in Figs. 9 to 12, the mounting layer 14 to be the mounting portion 11b for the electronic element 2 may be disposed. The mounting layer 14 can be manufactured by the same material and method as the metal layer 13. With the mounting layer 14, the electronic element 2 can be more appropriately mounted on the electronic element mounting substrate 1.

When the thickness T3 of the substrate 11 between the first main surface 111 of the substrate 11 and the third main surface 121 of the heat dissipator 12 is smaller than an interval W between the outer edge of the mounting layer 14 and the outer edge of the heat dissipator 12 in a plan perspective view, the heat of the electronic element 2 is likely to be transferred to the heat dissipator 12 than to the outside of the outer edge of the heat dissipator 12 in the direction in which the heat dissipators 12 are arrayed, and the heat transfer in the direction in which the heat dissipators 12 are arrayed can be suppressed. Therefore, it is possible to inhibit the heat from staying in the substrate 11, the heat dissipation of the electronic element mounting substrate 1 is improved, and the warp of the electronic element mounting substrate 1 can be suppressed.

When the mounting layer 14 is smaller than the heat dissipator 12 in a plan perspective view, as in the example illustrated in Figs. 9 to 12, transfer of heat of the electronic element 2 in the direction in which the heat dissipators 12 are arrayed can be suppressed by the heat dissipators 12. Therefore, it is possible to inhibit the heat from staying in the substrate 11, the heat dissipation of the electronic element mounting substrate 1 is improved, and the warp of the electronic element mounting substrate 1 can be suppressed.

The electronic element mounting substrate 1 according to the third embodiment may be formed by bonding another substrate 11 that is substantially the same material as the substrate 11 located on the first main surface 111 side of the substrate 11 and the third main surface 121 side of the heat dissipator 12 of the electronic element mounting substrate 1 according to the first embodiment.

The electronic element mounting substrate 1 according to the third embodiment can be manufactured using the same manufacturing method as the electronic element mounting substrate 1 according to the above-described embodiments.

### (Fourth Embodiment)

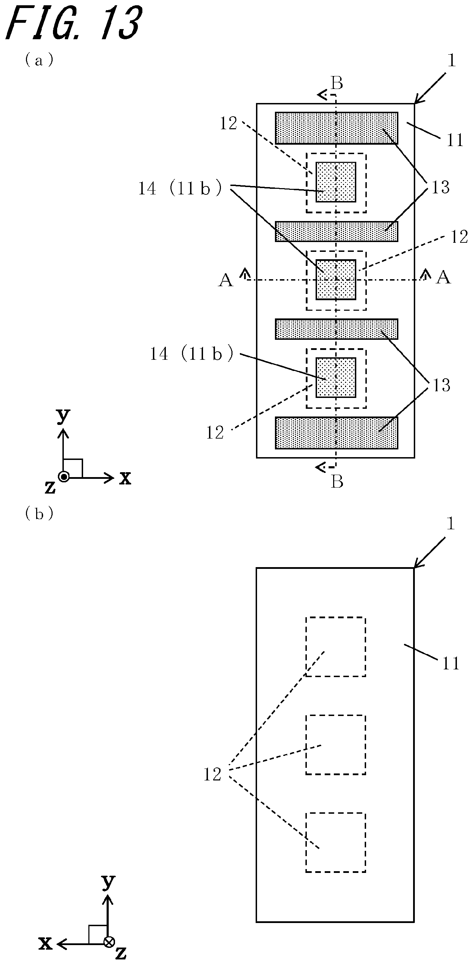

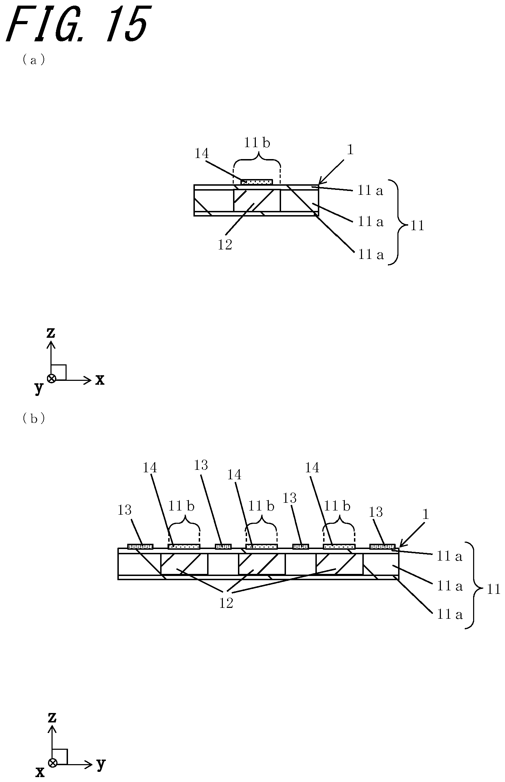

Next, an electronic device according to a fourth embodiment will be described with reference to Figs. 13 to 16.

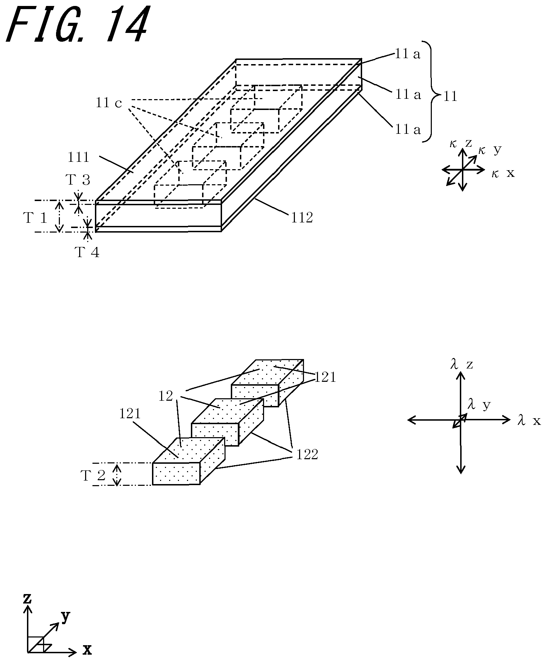

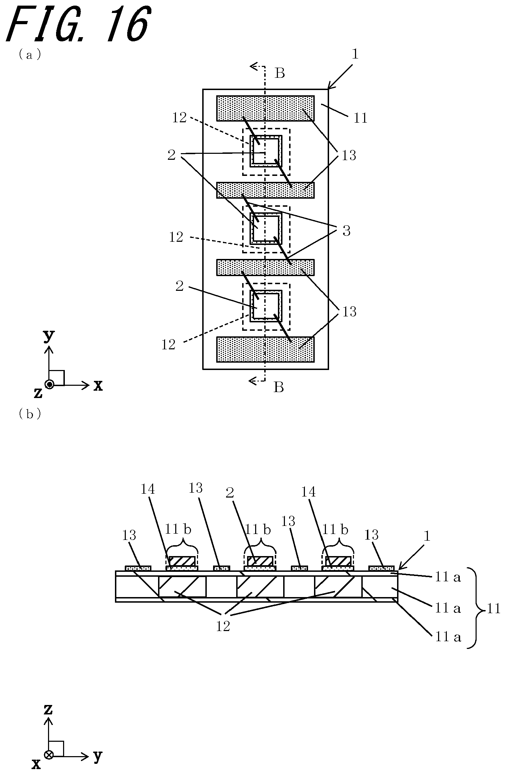

An electronic element mounting substrate 1 according to the fourth embodiment is different from the electronic element mounting substrate 1 according to the above-described embodiments in that the heat dissipator 12 is embedded in the substrate 11 so that the third main surface 121 and the fourth main surface 122 of the heat dissipator 12 are not exposed to the surfaces. In the fourth embodiment, the substrate 11 is formed of three insulating layers 11a. The heat dissipator 12 is shown by hatching in the example illustrated in Fig. 14. The metal layer 13 and the mounting layer 14 are shown by hatching in the example illustrated in Figs. 13(a), 15, and 16. In the substrate 11, in the example illustrated in Fig. 14, the outer surface of the substrate 11 and the inner surface of the hole 11c which are invisible in perspective are shown by broken lines. In the substrate 11, in the example illustrated in Figs. 13 and 16(a), a region that overlaps the side surface of the heat dissipator 12 in a plan perspective view is indicated by a broken line.

According to the electronic element mounting substrate 1 in the fourth embodiment, similarly to the electronic element mounting substrate 1 according to the above-described embodiments, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

When the heat dissipator 12 is embedded in the substrate 11 so that the third main surface 121 and the fourth main surface 122 of the heat dissipator 12 are not exposed to the surface, the electronic element mounting substrate 1 according to the fourth embodiment can be manufactured by appropriately bonding the third main surface 121 and the fourth main surface 122 of the heat dissipator 12 to the substrate 11. The third main surface 121 and the fourth main surface 122 of the heat dissipator 12 are respectively covered with the insulating layer 11a of the substrate 11 to obtain the electronic element mounting substrate 1.

In the electronic element mounting substrate 1 according to the fourth embodiment, the substrate thickness T1 of the substrate 11 is, for example, approximately 200 µm to 3,000 µm, and the substrate thickness T2 of the heat dissipator 12 is, for example, approximately 100 µm to 2,000 µm. The thickness T3 of the substrate 11 between the first main surface 111 of the substrate 11 and the third main surface 121 of the heat dissipator 12, and the thickness T4 of the substrate 11 between the second main surface 112 of the substrate 11 and the fourth main surface 122 of the heat dissipator 12 may be smaller than the substrate thickness T2 of the heat dissipator 12 (T2 > T3, T2 > T4). The same applies to the electronic element mounting substrates 1 according to the fifth to eighth embodiments.

In the electronic element mounting substrate 1 according to the fourth embodiment, similarly to the electronic element mounting substrate 1 according to the third embodiment, the thickness T3 of the substrate 11 between the first main surface 111 of the substrate 11 and the third main surface 121 of the heat dissipator 12 may be smaller than the interval W between the outer edge of the mounting layer 14 and the outer edge of the heat dissipator 12 in a plan perspective view.

In the electronic element mounting substrate 1 according to the fourth embodiment, similarly to the electronic element mounting substrate 1 according to the third embodiment, the mounting layer 14 may be disposed on the first main surface of the substrate 11. Similarly to the third embodiment, the mounting layer 14 may be smaller than the heat dissipator 12 in a plan perspective view.

The thickness T3 of the substrate 11 between the first main surface 111 of the substrate 11 and the third main surface 121 of the heat dissipator 12 and the thickness T4 of the substrate 11 between the second main surface 112 of the substrate 11 and the fourth main surface 122 of the heat dissipator 12 may be the same thickness as each other. For example, when the thickness T3 of the substrate 11 between the first main surface 111 of the substrate 11 and the third main surface 121 of the heat dissipator 12 is 100 µm, the thickness T4 of the substrate 11 between the second main surface 112 of the substrate 11 and the fourth main surface 122 of the heat dissipator 12 may be approximately 90 µm to 110 µm. Since the thicknesses of the substrate 11 across the heat dissipator 12 are equal to each other, the warp of the electronic element mounting substrate 1 can be reduced.

The electronic element mounting substrate 1 according to the fourth embodiment can be formed by bonding another substrate 11 having substantially the same material as the substrate 11 located on each of the first main surface 111 side and the second main surface 112 side of the substrate 11 of the electronic element mounting substrate 1 according to the first embodiment. The electronic element mounting substrate 1 according to the fourth embodiment may be formed by bonding another substrate 11 having substantially the same material as the substrate 11 located on the first main surface 111 side of the substrate 11 and the third main surface 121 side of the heat dissipator 12 of the electronic element mounting substrate 1 according to the second embodiment, or may be formed by bonding another substrate 11 having substantially the same material as the substrate 11 located on the second main surface 112 side of the substrate 11 and the fourth main surface 122 side of the heat dissipator 12 of the electronic element mounting substrate 1 according to the third embodiment.

The electronic element mounting substrate 1 according to the fourth embodiment can be manufactured using the same manufacturing method as the electronic element mounting substrate 1 according to the above-described embodiments.

### (Fifth Embodiment)

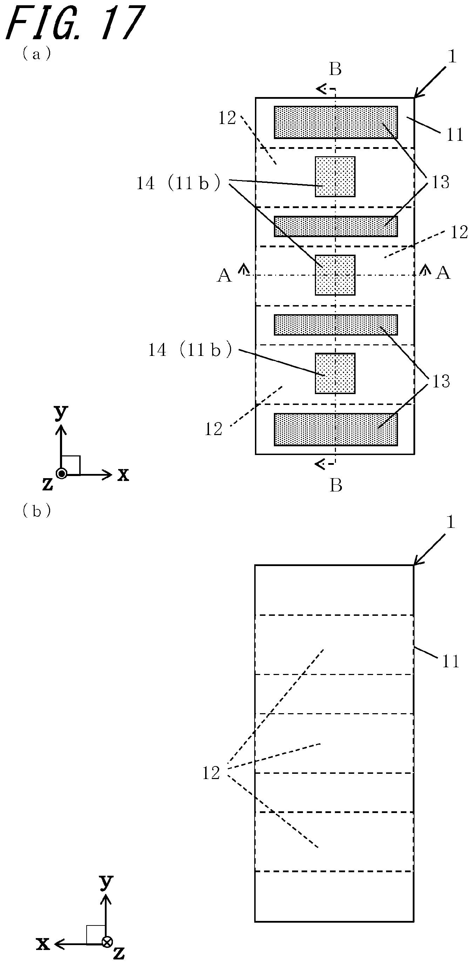

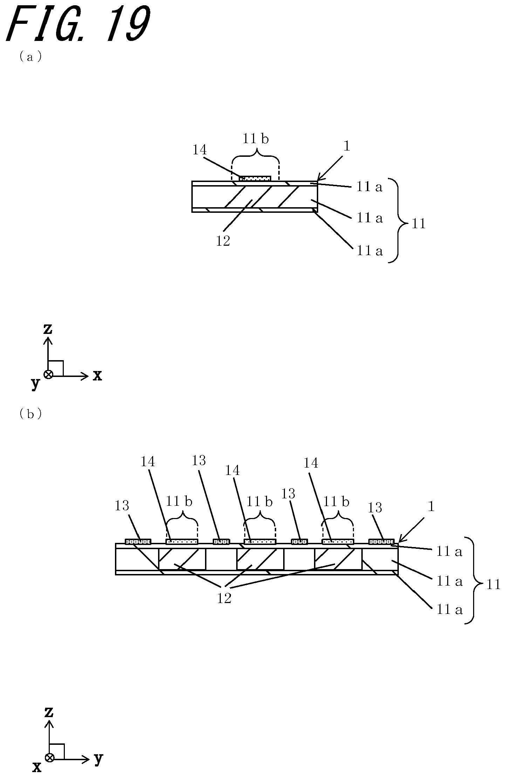

Next, an electronic device according to a fifth embodiment will be described with reference to Figs. 17 to 20.

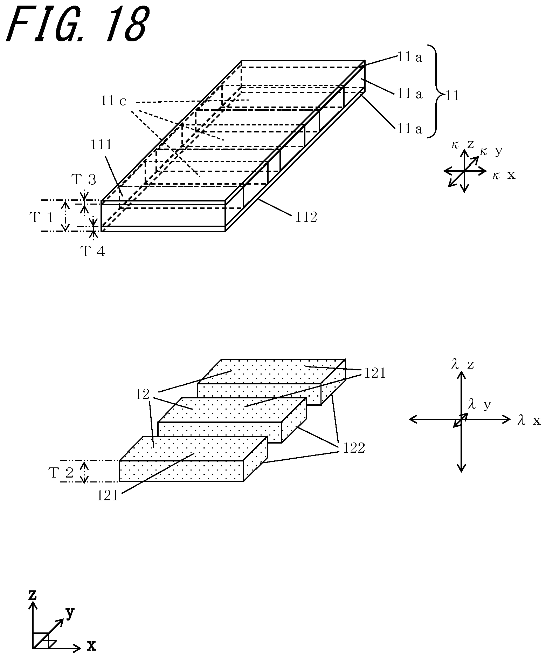

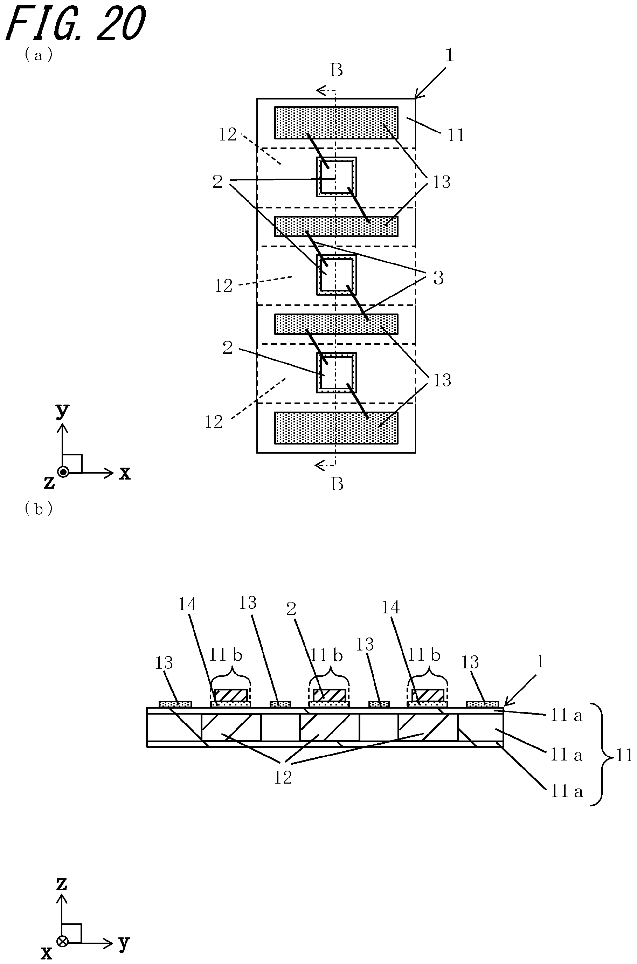

An electronic element mounting substrate 1 according to the fifth embodiment is different from the electronic element mounting substrate 1 according to the above-described embodiments in that the heat dissipator 12 is long in the direction perpendicular to the longitudinal direction of the substrate 11. In the fifth embodiment, the substrate 11 is formed of three insulating layers 11a. The heat dissipator 12 is shown by hatching in the example illustrated in Fig. 18. The metal layer 13 and the mounting layer 14 are shown by hatching in the example illustrated in Figs. 17(a), 19, and 20. In the substrate 11, in the example illustrated in Fig. 18, the outer surface of the substrate 11 and the inner surface of the hole 11c which are invisible in perspective are shown by broken lines. In the substrate 11, in the example illustrated in Fig. 17 and Fig. 20(a), a region that overlaps the side surface of the heat dissipator 12 in a plan perspective view is indicated by a broken line.

According to the electronic element mounting substrate 1 in the fifth embodiment, similarly to the electronic element mounting substrate 1 according to the above-described embodiments, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

In the electronic element mounting substrate 1 according to the fifth embodiment, when the heat dissipator 12 is long in the direction perpendicular to the longitudinal direction of the substrate 11, the heat transfer in the direction perpendicular to the direction in which the heat dissipators 12 are arrayed can be further increased. Therefore, the warp of the electronic element mounting substrate 1 can be suppressed.

As in the example illustrated in Figs. 17 to 20, when the heat dissipator 12 extends to the side surface of the substrate 11 in the direction perpendicular to the direction in which the heat dissipators 12 are arrayed, the heat transfer between the electronic elements 2 is suppressed, the heat dissipation of the electronic element mounting substrate 1 is improved, and the warp of the electronic element mounting substrate 1 can be suppressed.

In the electronic element mounting substrate 1 according to the fifth embodiment, the substrate thickness T1 of the substrate 11 is, for example, approximately 200 µm to 3,000 µm, and the substrate thickness T2 of the heat dissipator 12 is, for example, approximately 100 µm to 2,000 µm.

In the electronic element mounting substrate 1 according to the fifth embodiment, similarly to the electronic element mounting substrate 1 according to the third embodiment and the electronic element mounting substrate 1 according to the fourth embodiment, the thickness T3 of the substrate 11 between the first main surface 111 of the substrate 11 and the third main surface 121 of the heat dissipator 12 may be smaller than the interval W between the outer edge of the mounting layer 14 and the outer edge of the heat dissipator 12 in a plan perspective view.

In the electronic element mounting substrate 1 according to the fifth embodiment, similarly to the electronic element mounting substrate 1 according to the third embodiment and the electronic element mounting substrate 1 according to the fourth embodiment, the mounting layer 14 may be disposed on the first main surface of the substrate 11. Similarly to the third embodiment, the mounting layer 14 may be smaller than the heat dissipator 12 and located inside the heat dissipator 12 in a plan perspective view.

In the electronic element mounting substrate 1 according to the fifth embodiment, the third main surface 121 and the fourth main surface 122 of the heat dissipator 12 are respectively bonded by the insulating layer 11a so that the third main surface 121 and the fourth main surface 122 of the heat dissipator 12 are not exposed to the surface. In this case, the thickness T3 of the substrate 11 between the first main surface 111 of the substrate 11 and the third main surface 121 of the heat dissipator 12 and the thickness T4 of the substrate 11 between the second main surface 112 of the substrate 11 and the fourth main surface 122 of the heat dissipator 12 may be the same thickness as each other. For example, when the thickness T3 of the substrate 11 between the first main surface 111 of the substrate 11 and the third main surface 121 of the heat dissipator 12 is 100 µm, the thickness T4 of the substrate 11 between the second main surface 112 of the substrate 11 and the fourth main surface 122 of the heat dissipator 12 may be approximately 90 µm to 110 µm. Since the thicknesses of the substrate 11 across the heat dissipator 12 are equal to each other, the warp of the electronic element mounting substrate 1 can be reduced.

The electronic element mounting substrate 1 according to the fifth embodiment can be manufactured using the same manufacturing method as the electronic element mounting substrate 1 according to the above-described embodiments.

### (Sixth Embodiment)

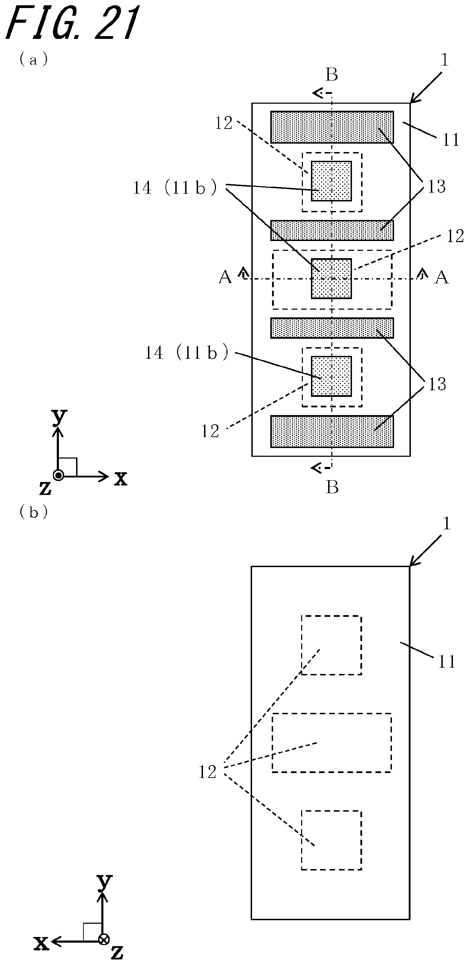

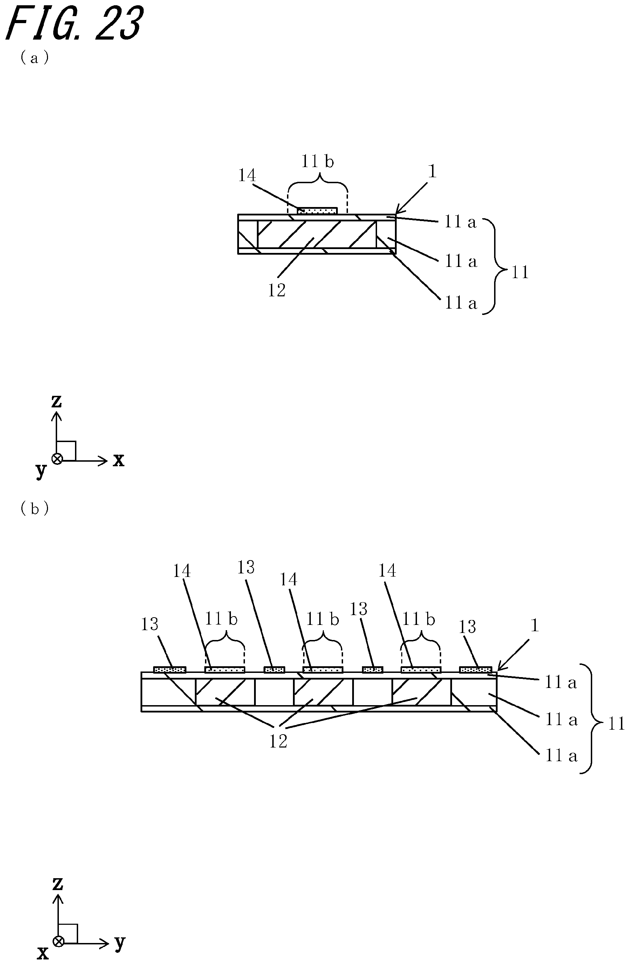

Next, an electronic device according to a sixth embodiment will be described with reference to Figs. 21 to 24.

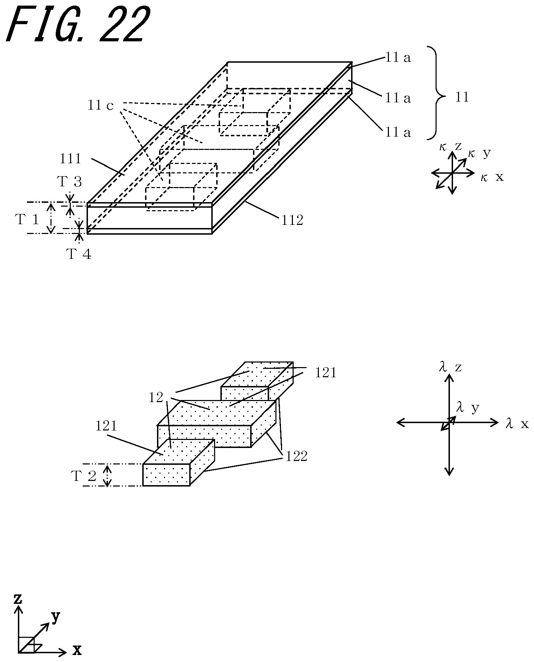

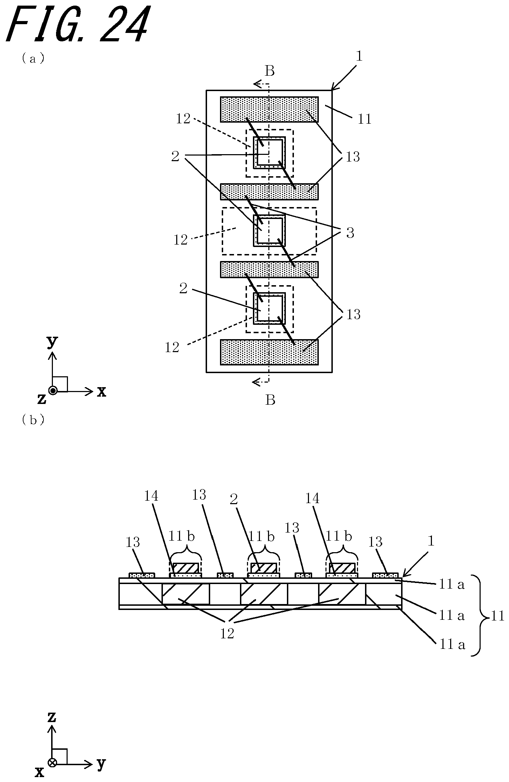

An electronic element mounting substrate 1 according to the sixth embodiment is different from the electronic element mounting substrate 1 according to the above-described embodiments in that the sizes of the plurality of heat dissipators 12 are different from each other in a plan perspective view. The heat dissipator 12 is shown by hatching in the example illustrated in Fig. 22. The metal layer 13 and the mounting layer 14 are shown by hatching in the example illustrated in Figs. 21(a), 23, and 24(a). In the substrate 11, in the example illustrated in Figs. 21 and 24, a region that overlaps the side surface of the heat dissipator 12 in a plan perspective view is indicated by a broken line.

According to the electronic element mounting substrate 1 in the sixth embodiment, similarly to the electronic element mounting substrate 1 according to the above-described embodiments, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

In the heat dissipator 12, as in the example illustrated in Figs. 21 to 24, when the size of the heat dissipator 12 disposed in the vicinity of the center portion of the electronic element mounting substrate 1 is larger than the size of the heat dissipator 12 disposed in the vicinity of the outer periphery portion of the electronic element mounting substrate 1, the heat transfer in the vicinity of the center portion of the electronic element mounting substrate 1 in the direction perpendicular to the direction in which the heat dissipators 12 are arrayed can be increased. Therefore, it is possible to inhibit the heat from staying in the vicinity of the center portion of the substrate 11, the heat dissipation of the electronic element mounting substrate 1 is improved, and the warp of the electronic element mounting substrate 1 can be suppressed.

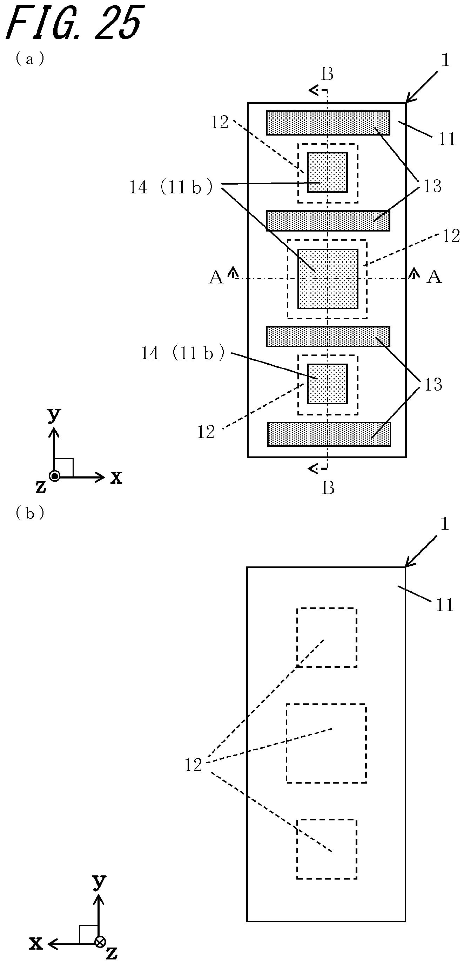

The electronic element mounting substrate 1 according to the sixth embodiment can be suitably used also in an electronic device in which the sizes of the plurality of electronic elements 2 to be mounted are different from each other. As in the example illustrated in Fig. 25, the sizes of the mounting layers 14 may be different from each other in a plan view.

The electronic element mounting substrate 1 according to the sixth embodiment can be manufactured using the same manufacturing method as the electronic element mounting substrate 1 according to the above-described embodiments.

### (Seventh Embodiment)

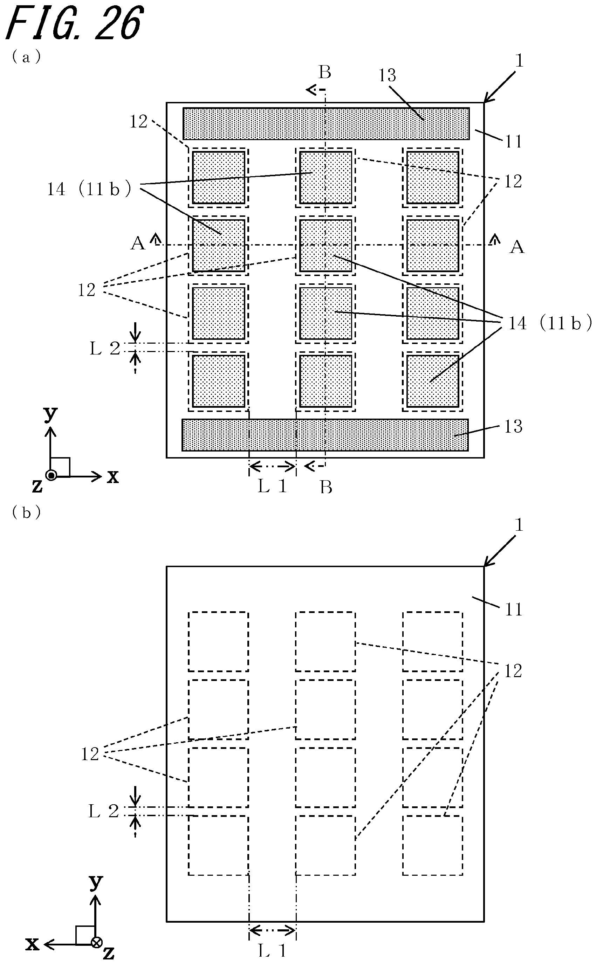

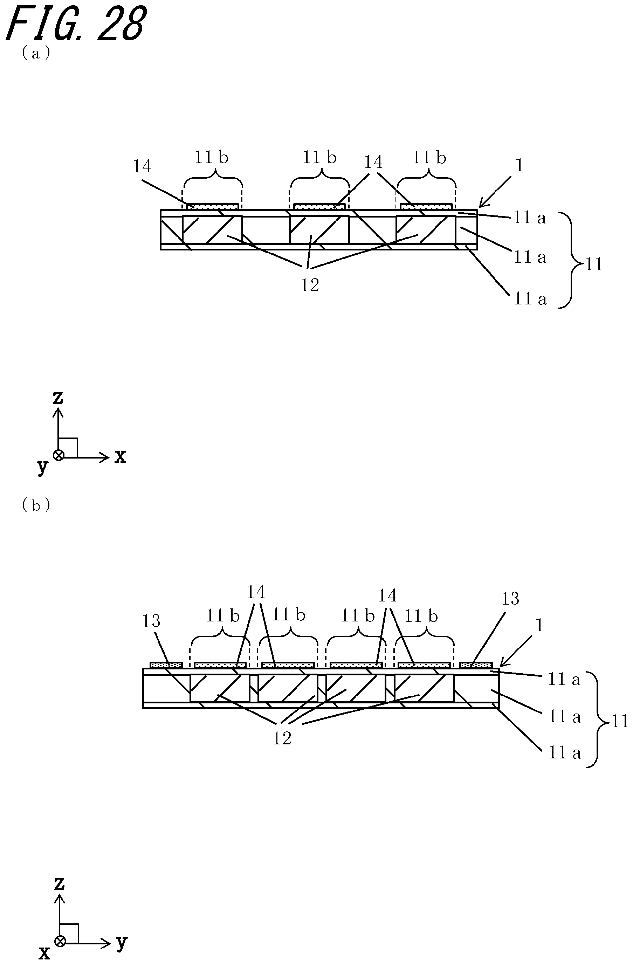

Next, an electronic device according to a seventh embodiment will be described with reference to Figs. 26 to 29.

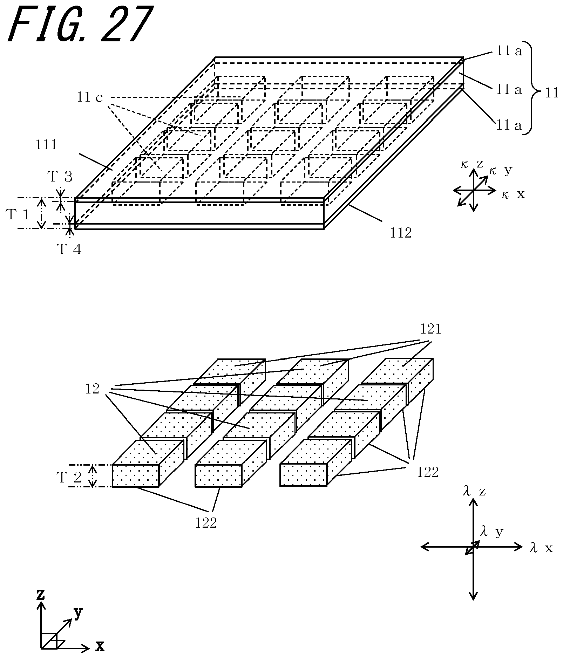

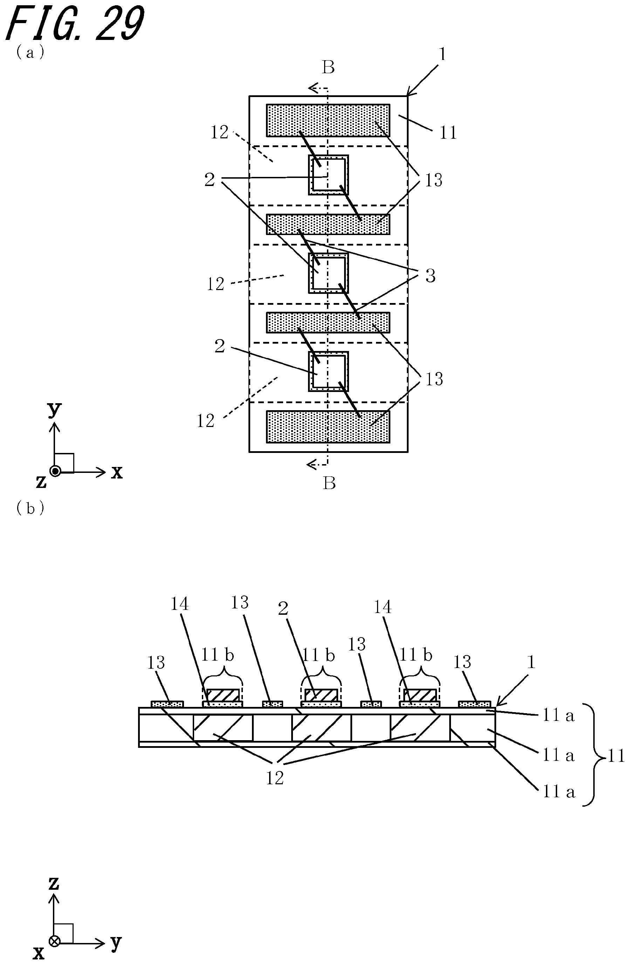

In an electronic element mounting substrate 1 according to the seventh embodiment, a plurality of arrayed heat dissipators 12 is disposed in the direction perpendicular to the direction in which the heat dissipators 12 are arrayed in a plan view. In the seventh embodiment, the substrate 11 is formed of three insulating layers 11a. The heat dissipator 12 is shown by hatching in the example illustrated in Fig. 27. The metal layer 13 and the mounting layer 14 are shown by hatching in the example illustrated in Figs. 26, 28, and 29. In the substrate 11, in the example illustrated in Fig. 27, the outer surface of the substrate 11 and the inner surface of the hole 11c which are invisible in perspective are shown by broken lines. In the substrate 11, in the example illustrated in Fig. 26 and Fig. 29(a), a region that overlaps the side surface of the heat dissipator 12 in a plan perspective view is indicated by a broken line.

According to the electronic element mounting substrate 1 in the seventh embodiment, similarly to the electronic element mounting substrate 1 according to the above-described embodiments, the heat transfer in the direction in which the heat dissipators 12 are arrayed can be suppressed, and the heat transfer in the direction perpendicular to the direction in which the heat dissipators 12 are arrayed can be increased. Therefore, it is possible to inhibit the heat from staying in the substrate 11, the heat dissipation of the electronic element mounting substrate 1 is improved, and the warp of the electronic element mounting substrate 1 can be suppressed.

When an interval L1 between adjacent heat dissipators 12 in the direction orthogonal to the direction in which the heat dissipators 12 are arrayed is larger than an interval L2 between adjacent heat dissipators in the direction in which the dissipators 12 are arrayed (L1 > L2), it is difficult to obstruct the heat transfer in the direction orthogonal to the direction in which the heat dissipators 12 are arrayed. Therefore, the heat dissipation of the electronic element mounting substrate 1 is improved, and the warp of the electronic element mounting substrate 1 can be suppressed. In particular, the interval L1 between adjacent heat dissipators 12 in the direction orthogonal to the direction in which the heat dissipators 12 are arrayed may be twice or more the interval L2 between adjacent heat dissipators in the direction in which the heat dissipators 12 are arrayed (L1 > 2L2).

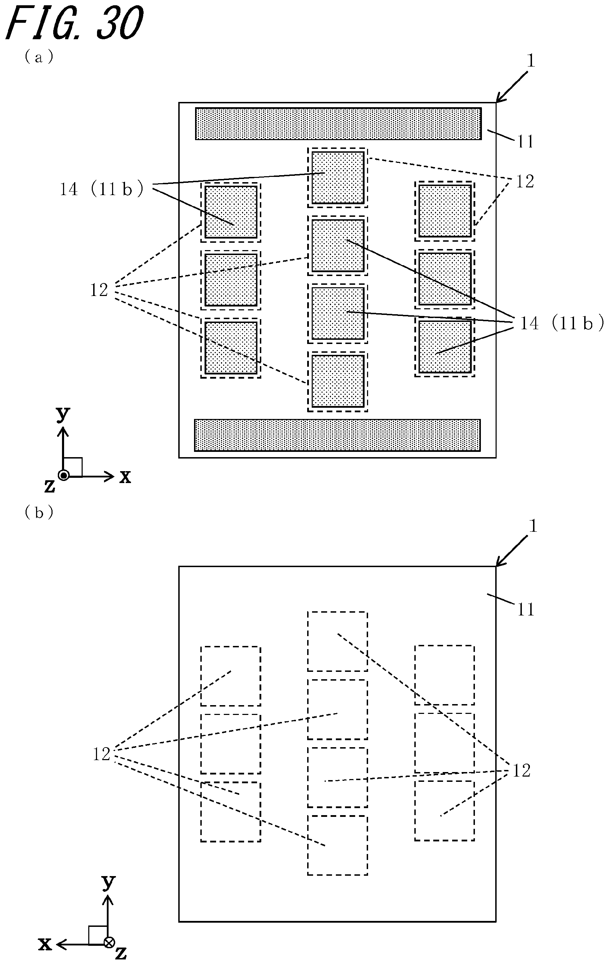

As in the example illustrated in Fig. 30, when a plurality of arrayed heat dissipators 12 disposed in the direction orthogonal to the direction in which the heat dissipators 12 are arrayed is shifted from each other in the direction in which the heat dissipators 12 are arrayed, it is more difficult to obstruct the heat transfer in the direction orthogonal to the direction in which the heat dissipators 12 are arrayed. Therefore, the heat dissipation of the electronic element mounting substrate 1 is improved, and the warp of the electronic element mounting substrate 1 can be suppressed.

The electronic element mounting substrate 1 according to the seventh embodiment can be manufactured using the same manufacturing method as the electronic element mounting substrate 1 according to the above-described embodiments.

In the example illustrated in Figs. 26 to 30, although the heat dissipators 12 are disposed in three rows in the direction orthogonal to the direction in which the heat dissipators 12 are arrayed, the heat dissipators 12 may be disposed in two rows, or four or more rows in the direction orthogonal to the direction in which the heat dissipators 12 are arrayed.

### (Eighth Embodiment)

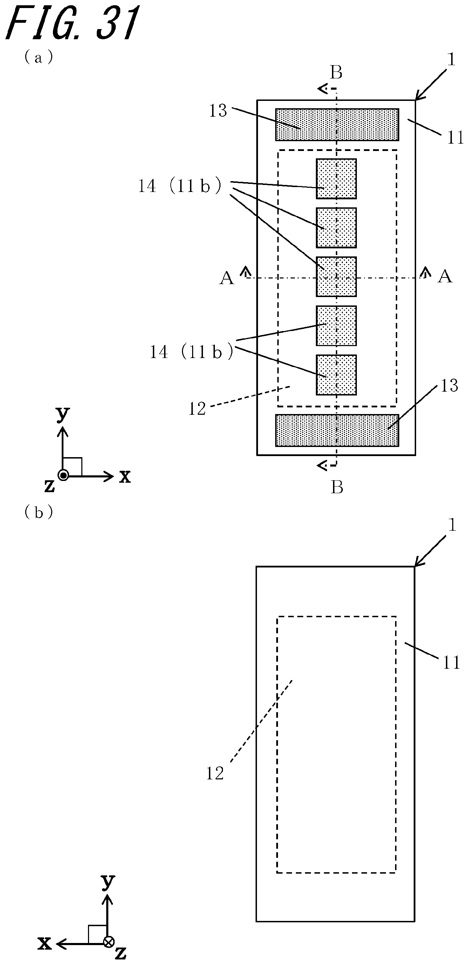

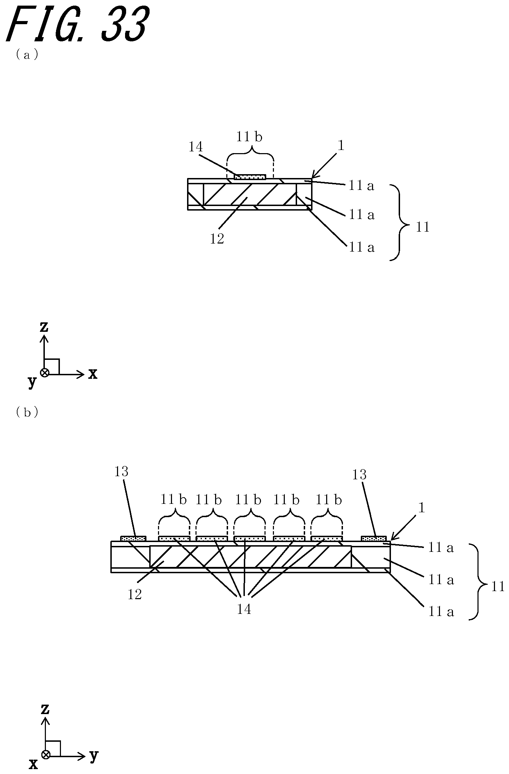

Next, an electronic device according to an eighth embodiment will be described with reference to Figs. 31 to 34.

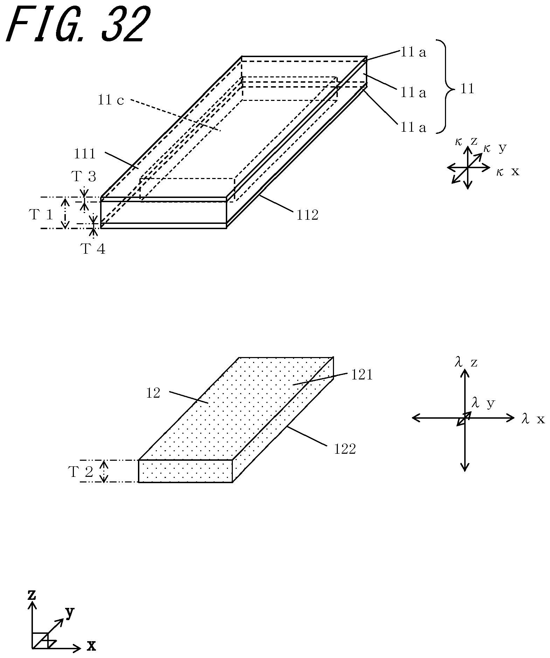

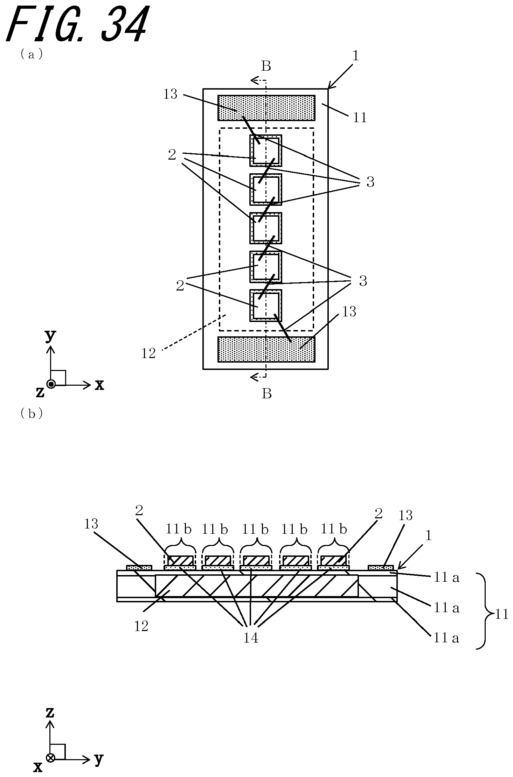

In an electronic element mounting substrate 1 according to the eighth embodiment, one heat dissipator 12 is positioned to overlap the mounting portions 11b for the plurality of electronic components 2 in a plan view. In the eighth embodiment, the substrate 11 is formed of three insulating layers 11a. The heat dissipator 12 is shown by hatching in the example illustrated in Fig. 32. The metal layer 13 and the mounting layer 14 are shown by hatching in the example illustrated in Figs. 31, 33, and 34. In the substrate 11, in the example illustrated in Fig. 32, the outer surface of the substrate 11 and the inner surface of the hole 11c which are invisible in perspective are shown by broken lines. In the substrate 11, in the example illustrated in Fig. 31 and Fig. 34(a), a region that overlaps the side surface of the heat dissipator 12 in a plan perspective view is indicated by a broken line. In a plan perspective view, the heat dissipator 12 has a rectangular shape and the mounting portions 11b for the electronic components 2 are arrayed in the longitudinal direction of the heat dissipator 12. The heat dissipator 12 may have a quadrangular shape in a plan perspective view.

According to the electronic element mounting substrate 1 in the eighth embodiment, similarly to the electronic element mounting substrate 1 according to the above-described embodiments, the heat transfer in the direction of the mounting portions 11b for adjacent electronic components 2 can be suppressed, and the heat transfer in the direction perpendicular to the direction of the mounting portions 11b for the adjacent electronic components 2 can be increased. Therefore, it is possible to inhibit the heat from staying in the substrate 11, the heat dissipation of the electronic element mounting substrate 1 is improved, and the warp of the electronic element mounting substrate 1 can be suppressed.

One heat dissipator 12 overlaps the mounting portions 11b for the plurality of electronic components 2 in a plan perspective view. In the example illustrated in Figs. 31 to 34, one heat dissipator 12 overlaps the mounting portions 11b for the five electronic components 2 in a plan perspective view. When the thermal conductivity λy in the direction (y direction) in which the mounting portions 11a for the plurality of electronic components 2 are disposed is smaller than the thermal conductivity κy of the substrate 11 (λy < κy), compared to the first to seventh embodiments, the heat transfer between adjacent electronic components 2 can be suppressed and the interval between mounting portions 11a can be small. Therefore, the heat dissipator 12 can be suitably used as a small electronic device.

When a light emitting element is used as the electronic component 2, many light emitting elements can be mounted by reducing the interval between the mounting portions 11a, and a light emitting device with good luminance can be obtained.

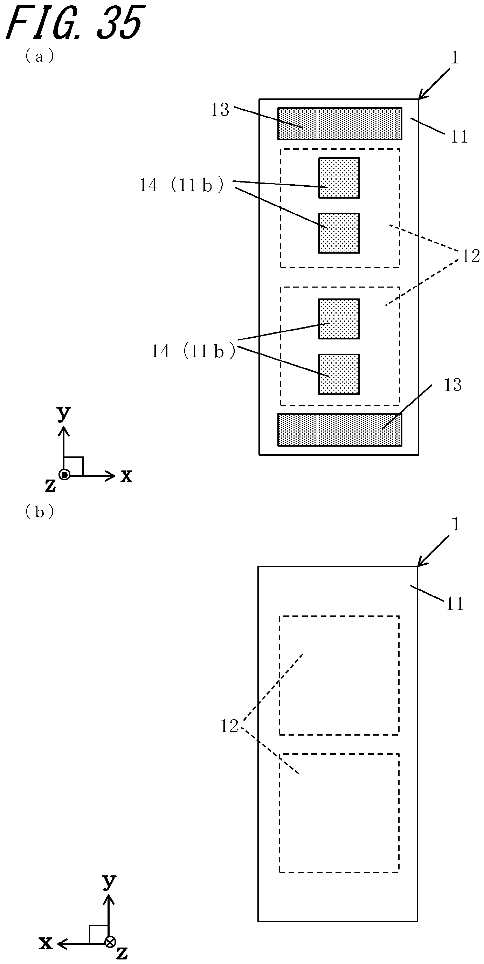

As in the example illustrated in Fig. 35, a plurality of heat dissipators 12 positioned to overlap the mounting portions 11b for the plurality of electronic components 2 may be arrayed in the direction in which the mounting portions 11b for the plurality of electronic components 2 are arranged. In this case, each of the heat dissipator 12 is positioned such that the heat conduction in the direction perpendicular to the direction in which the front heat dissipators are arrayed is greater than the heat conduction in the direction in which the heat dissipators 12 are arrayed.

The electronic element mounting substrate 1 according to the eighth embodiment can be manufactured using the same manufacturing method as the electronic element mounting substrate 1 according to the above-described embodiments.

The present disclosure is not limited to the example embodiments described above, and various modifications are possible. For example, the metal layer 13 positioned on the first main surface 111 of the substrate 11 is formed by a thin film method in the above-described examples, and may be a metal layer using a known co-fire method or post-fire method in the related art. When such a metal layer 13 is used, the metal layer 13 is disposed in advance on the first main surface of the substrate 11 before the substrate 11 and the heat dissipator 12 are bonded. The above-described method may be used in order to improve the flatness of the substrate 11.

The electronic element mounting substrate 1 may have a chamfer, a cutout, or the like at corner portions or side portions of the substrate 11 in a plan view.

The electronic element mounting substrate 1 according to the first embodiment to the electronic element mounting substrate 1 according to the seventh embodiment are formed by single to three insulating layers 11a. The number of insulating layers 11a may be different from those in the above embodiments. For example, the electronic element mounting substrate 1 according to the first embodiment may be formed of two or more insulating layers 11a.

The electronic element mounting substrate 1 according to the first embodiment to the electronic element mounting substrate 1 according to the seventh embodiment include three heat dissipators 12 accommodated in the three holes 11c of the substrate 11, and may be an electronic element mounting substrate 1 in which four or more holes 11c and the heat dissipators 12 are arranged.

The electronic element mounting substrate 1 according to the first embodiment to the electronic element mounting substrate 1 according to the seventh embodiment may be combined. For example, in the electronic element mounting substrate 1 according to the third embodiment, the electronic element mounting substrate 1 according to the fourth embodiment, the electronic element mounting substrate 1 according to the sixth embodiment, and the electronic device mounting according to the seventh embodiment, the heat dissipator 12 may have a circular shape in a plan view as in the electronic element mounting substrate 1 according to the second embodiment.

## Claims

1. An electronic element mounting substrate comprising:
a substrate in a quadrangular shape, comprising a first main surface and a second main surface opposite to the first main surface; and
heat dissipators arrayed and embedded in the substrate, made of a carbon material, and comprising a third main surface located on the first main surface side in a thickness direction and a fourth main surface opposite to the third main surface, wherein
the heat dissipators have, in a plan perspective view, greater heat conduction in a direction perpendicular to a direction in which the heat dissipators are arrayed than heat conduction in the direction in which the heat dissipators are arrayed.

2. The electronic element mounting substrate according to claim 1, wherein
the heat dissipators have, in a longitudinal sectional view in a direction in which the heat dissipators are arrayed, greater heat conduction in the thickness direction than a direction perpendicular to the thickness direction.

3. The electronic element mounting substrate according to claim 1 or 2, wherein
the substrate has a rectangular shape, and
the heat dissipators are arrayed in a longitudinal direction of the substrate in a plan view.

4. The electronic element mounting substrate according to any one of claims 1 to 3, wherein
the third main surface of the heat dissipators is exposed to the first main surface side in a thickness direction of the substrate.

5. The electronic element mounting substrate according to any one of claims 1 to 4, wherein
the fourth main surface of the heat dissipators is exposed to the second main surface side in a thickness direction of the substrate.

6. An electronic device comprising:
the electronic element mounting substrate according to any one of claims 1 to 5;
an electronic element mounted on a mounting portion of the electronic element mounting substrate; and
a wiring board or an electronic element housing package on which the electronic element mounting substrate is mounted.

7. An electronic module comprising:
the electronic device according to claim 6; and
a module substrate to which the electronic device is connected.
